# EUROPEAN PATENT SPECIFICATION

(11) **EP 1 081 552 B1**
(45) Date of publication and mention of the grant of the patent: **09.11.2011**
(21) Application number: 00118222.9
(22) Date of filing: 01.09.2000
(51) Int. Cl.: G03F 7/033

(54) **Lithographic printing plate precursor**
Lithographische Druckplattenvorstufe
Précurseur de plaque d'impression lithographique

(30) Priority: 03.09.1999 JP 25063799
(43) Date of publication of application: 07.03.2001
(73) Proprietor: FUJIFILM Corporation, Minato-ku Tokyo (JP)
(72) Inventor: Okamoto, Yasuo, Fuji Photo Film Co., Ltd., Haibara-gun, Shizuoka (JP); Sano, Kenji, Fuji Photo Film Co., Ltd., Haibara-gun, Shizuoka (JP)
(74) Representative: HOFFMANN EITLE

(56) References cited:
- EP-A- 0 274 075
- EP-A- 0 313 007
- WO-A-90/09622

## Description

### FIELD OF THE INVENTION

The present invention relates to a lithographic printing plate precursor and, more particularly, to a photo polymerizable lithographic printing plate precursor having high sensitivity and ensuring high mechanical strength.

### BACKGROUND OF THE INVENTION

Hitherto, negative-working lithographic printing plate precursors using photo polymerizable compositions in their photosensitive layers have been widely well-known, and they are various in kind. In a general method which has for far been adopted for making a lithographic printing plate from such a printing plate precursor, imagewise exposure is carried out by superimposing a transparent original negative (a litho film) on the photosensitive layer (photo polymerizable layer) of the precursor and exposing the photosensitive layer to ultraviolet light via the original negative. Therefore, a lot of time and energy is required for platemaking operations.

With the recent development of image-forming technology, photopolymers having high sensitivities to rays in the visible region have come to be requested. They are photosensitive materials suitable for the platemaking by, e.g., non-contact projective exposure or visible laser scanning, and photopolymers of photo polymerization type are most sensitive and most promissing. As the visible laser, the beams of 488 nm and 514.5 nm from Ar laser, the second harmonic beams from semiconductor laser (SHG-LD, 350 to 600 nm) and the beam of 532 nm from SHG-YAG laser are considered to have favorable prospects.

By using a certain photo polymerizable composition having high sensitivity in the photosensitive layer of a lithographic printing plate precursor, it becomes possible without an original film to form a letter original or an image original directly on the plate surface by scanning the plate surface with a narrowed beam of laser. For instance, the photo polymerizable compositions disclosed in JP-B-61-9621 (the term "JP-B" as used herein means an "examined Japanese patent publication"), JP-A-63-178105 and JP-A-2-244050 (the term "JP-A" as used herein means an "unexamined published Japanese patent application") enable the direct platemaking without using an original film.

However, even when any of the photo polymerizable compositions described above is used in the photosensitive layer of a lithographic printing plate precursor, it can occur that the printing plate made by subjecting the precursor to scanning exposure by means of a laser exposure apparatus having any of the laser light sources described above is inferior in impression capacity, particularly in small-dot reproducibility (highlight characteristic), because the sensitivity of the precursor is still insufficient and the images formed therein are failure of strength.

Additionally, the exposure with an apparatus utilising a light source other than laser can also present those drawbacks.

US-A-4 940 646 discloses a photosensitive mixture comprising inter alia a negative-working light-hardenable substance which may be a mixture of an olefinically unsaturated radically polymerizable compound and a photoinitiator for radical polymerisation, and a polyvinyl acetal having a hydroxyl number of 150-600.

US-A-4,845,011 discloses the preparation of a lithographic printing plate precursor in which the photosensitive layer comprises pentaerythrittriacrylate, polyvinylpropionate as a polyvinyl acetal having alkali soluble groups.and a photopolymerisation initiator.

### SUMMARY OF THE INVENTION

Therefore, an object of the present invention is to overcome the drawbacks of conventional arts and thereby provide a lithographic printing plate precursor which can ensure high impression capacity, especially excellent small-dot reproducibility, in the plate made therefrom because it has sufficient sensitivity and the images formed therein have enough strength.

As a result of our intensive studies made for attaining the object mentioned above, it has been found that the drawbacks of conventional arts can be overcome by using polyvinyl acetal having alkali-soluble groups as binder component of the photo polymerizable layer, thereby achieving the present invention.

Thus, the present invention provides a lithographic printing plate precursor comprising a photosensitive layer provided on a substrate, said photosensitive layer being a photo-polymerizable layer comprising an addition polymerizable monomer, a photo-polymerization initiator and a polyvinyl acetal having alkali-soluble groups represented by the following formula (I): 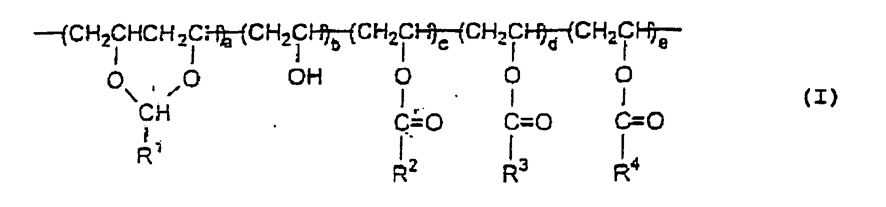 wherein R¹ and R² each represents an unsubstituted or substituted alkyl group or a hydrogen atom; R⁴ represents an aliphatic or aromatic hydrocarbon group which may have a hydroxyl group or a nitrile group; a and b each represent a positive number; c and e each represents a number of 0 or more; d represents a number of more than 0; and R³ represents a group selected from:

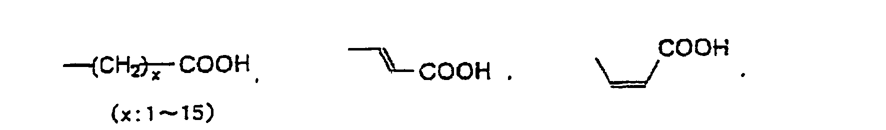

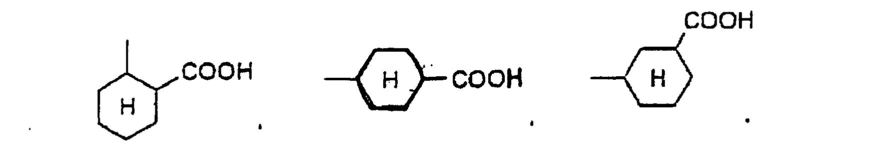

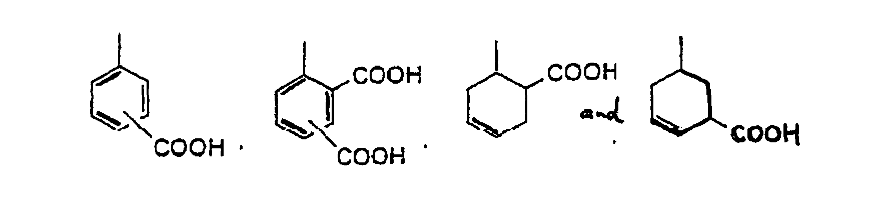

The conventional lithographic printing plate precursors of photo polymerization type have a problem of being inferior in small-dot reproducibility. And a causal factor of such a inferiority is thought to be the liability of the small-dot image areas of the lithographic printing plates made from the conventional printing plate precursors to suffer damage by external force working on contact with a blanket cylinder.

By contrast, the present lithographic printing plate precursor (i.e., the lithographic printing plate precursor of the present invention) is thought to have controlled solubility in an alkali used at the time of development because the polyvinyl acetal having alkali-soluble groups, which is comprised as binder component in its photo polymerizable layer, interacts with an addition polymerizable monomer and a substrate; as a result, the plate made therefrom is hardly affected by external force working upon contact with a blanket cylinder at the time of printing.

### DETAILED DESCRIPTION OF THE INVENTION

Lithographic printing plate precursors according to the present invention are described below in detail.

### [Polyvinyl Acetal Having Alkali-soluble Groups]

First of all, the most important constituent of the present lithographic printing plate precursor, namely polyvinyl acetal having alkali-soluble groups, is illustrated.

The polyvinyl acetal having alkali-soluble groups, which is contained as a binder component in a photopolymerisable layer of the present lithographic printing plate precursor is represented by the following formula (I): 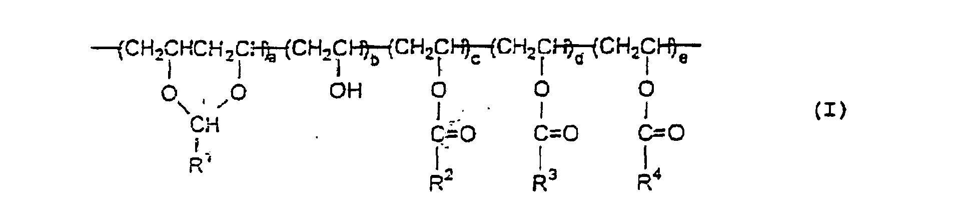 wherein R¹ and R² each represent an unsubstituted or substituted alkyl group or a hydrogen atom (preferably they are alkyl groups containing 1 to 15 carbon atoms); R³ represents a group selected from:

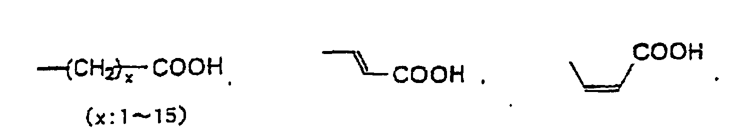

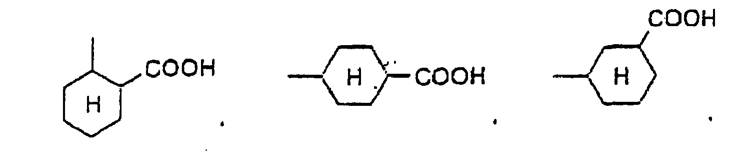

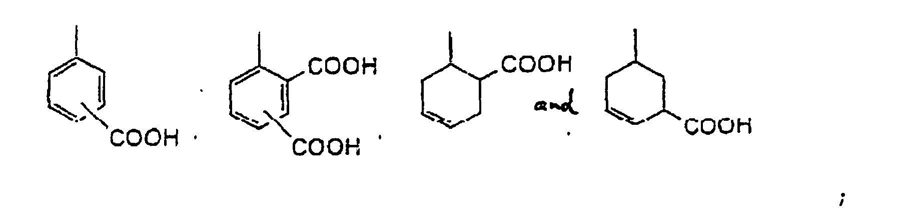

R⁴ represents an aliphatic or aromatic hydrocarbon group which may have a hydroxyl group or a nitrile group; a and b each represent a positive number; c and e each represent a number of 0 or more; and d represents a number of more than 0.

The following are preferred examples of R⁴: 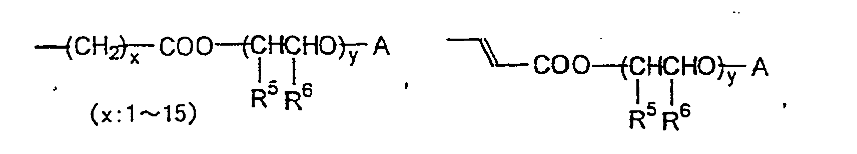 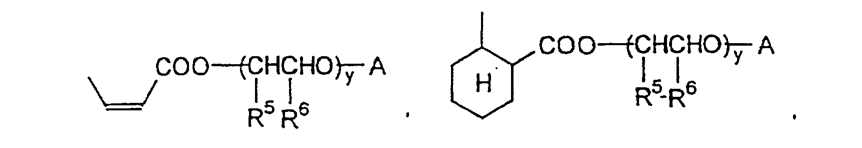 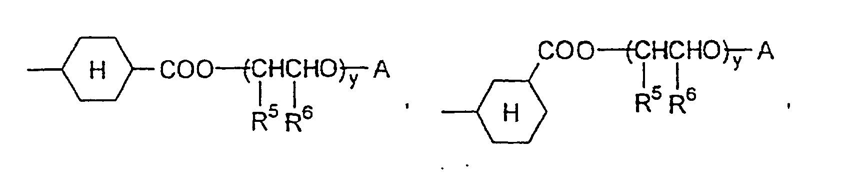 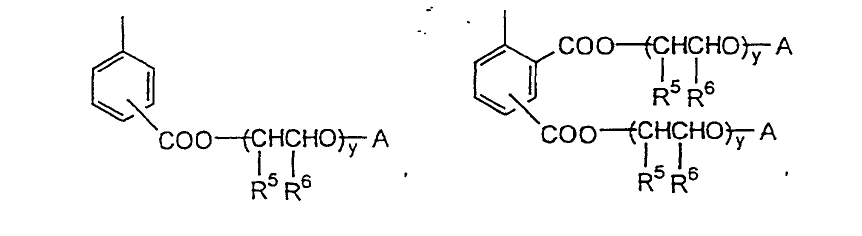 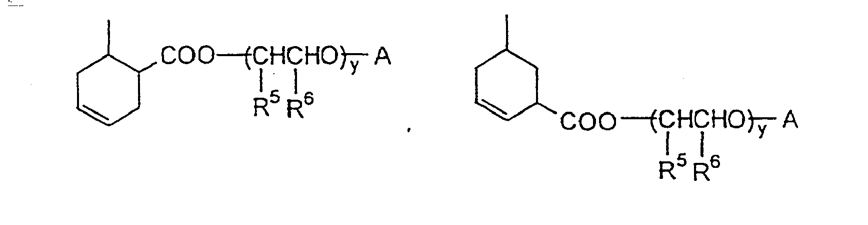 wherein R⁵ and R⁶ each represent H or CH₃, y represents a number of from 1 to 20, and A represents H or CN.

These polyvinyl acetals having alkali-soluble groups are used in a proportion of from 10 to 90 % by weight (hereinafter abbreviated as "%"), preferably from 20 to 70 %, to the total ingredients in the photo polymerizable layer of the present lithographic printing plate precursor.

### [Addition Polymerizable Monomer]

Next the secondarily important constituent of the present lithographic printing plate precursor, namely an addition polymerizable monomer, is illustrated.

The addition polymerizable monomer incorporated in a photo polymerizable layer of the present lithographic printing plate precursor has no particular restriction so far as it can interact with the polyvinyl acetal to suppress the solubility of the photopolymerizable layer in an alkali used for development, but it is preferable for the monomer to have an urethane linkage.

The addition polymerizable monomer having an urethane linkage is not limited to particular ones, but the following are suitable examples thereof.
(i) Addition polymerizable monomers which each have an ethylenically unsaturated double bond-containing alkylene oxide group and an urethane linkage.
   These monomers, though they are not limited to particular ones, are preferably the products of the reaction of isocyanate compounds with alcohols represented by the following formula (II): 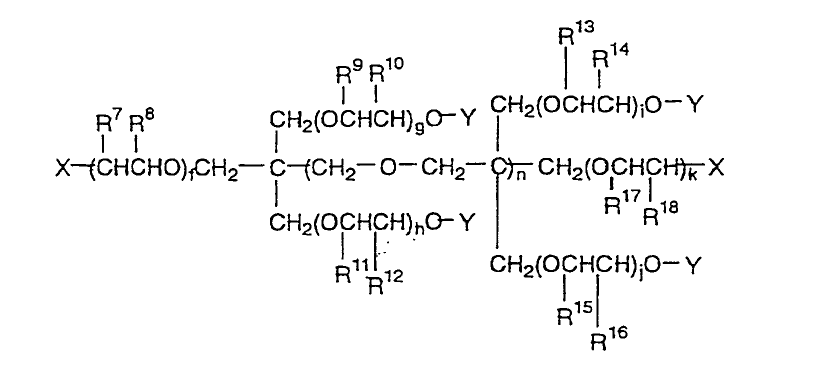 wherein R⁷, R⁸, R⁹, R¹⁰, R¹¹, R¹², R¹³, R¹⁴, R¹⁵, R¹⁶, R¹⁷ and R¹⁸ each represent a hydrogen atom, an alkyl group with 1 to 10 carbon atoms or a phenyl group; Y represents a hydrogen atom or a group represented by the following formula (III), 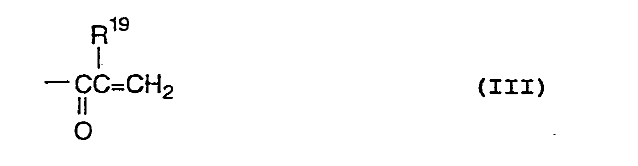 (wherein R¹⁹ represents a hydrogen atom or a methyl group), provided that at least one of Y is a hydrogen atom, and each X represents an alkyl group, an aryl group, an alkoxy group, -OH or a group represented by the following formula (III), 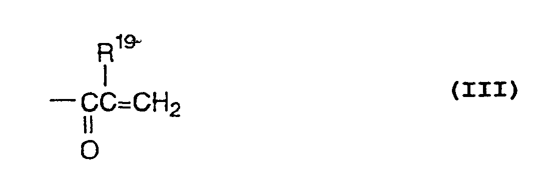 (wherein R¹⁹ represents a hydrogen atom or a methyl group), provided that at least one of all X and Y is a group represented by formula (III); and n, f, g, h, i, j and k are each 0 or a positive number.

Examples of isocyanate compounds usable in the foregoing reaction are illustrated below:

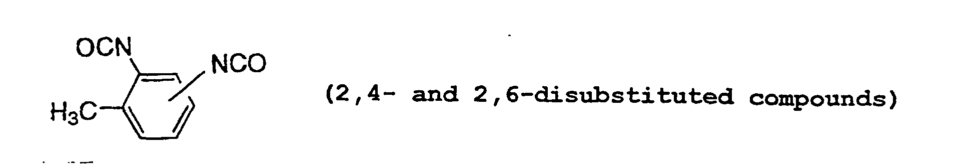

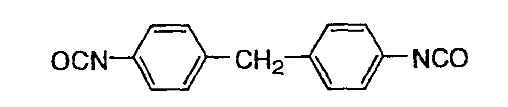

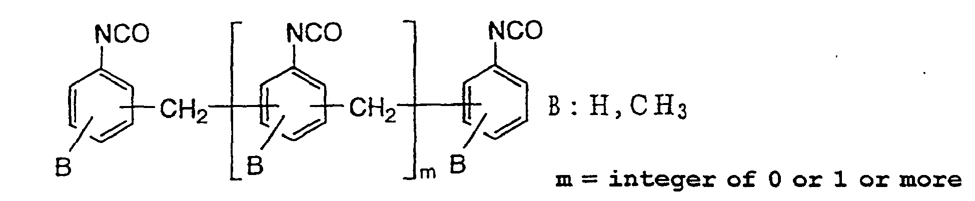

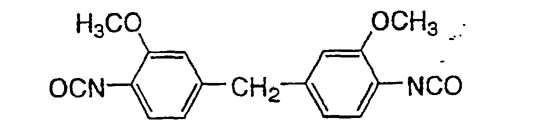

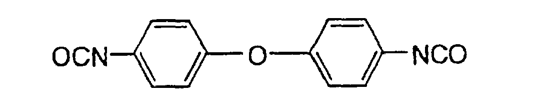

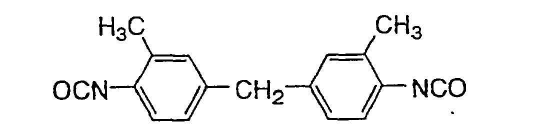

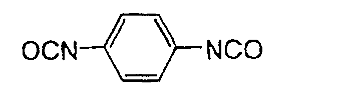

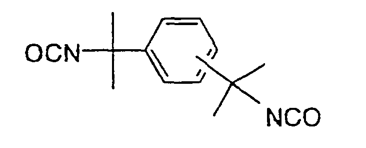

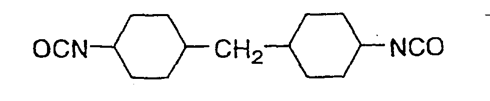

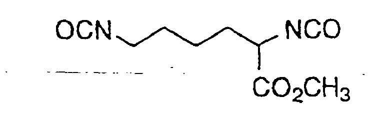

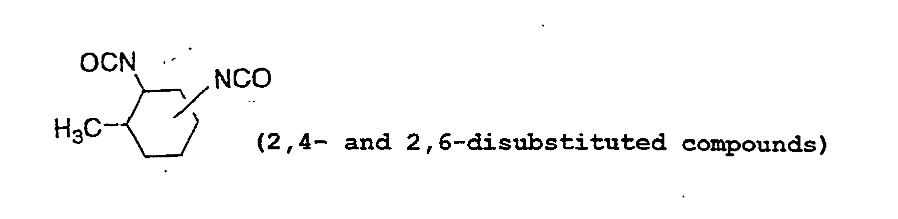

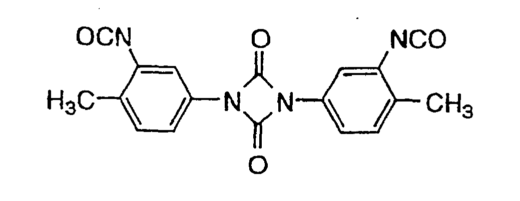

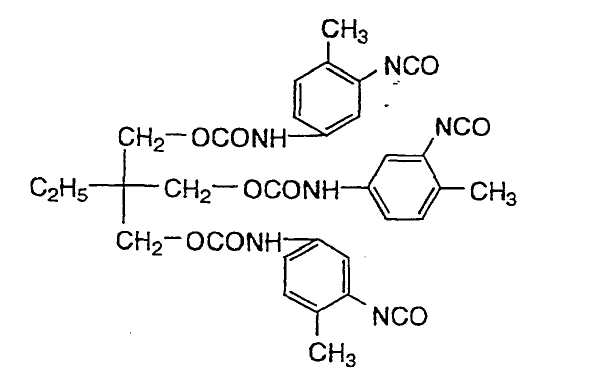

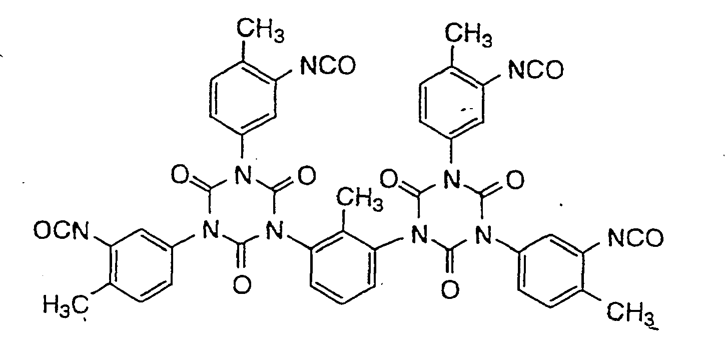

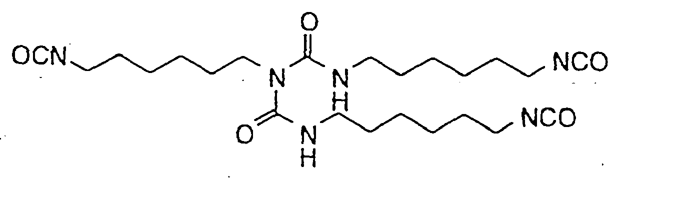

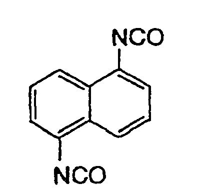

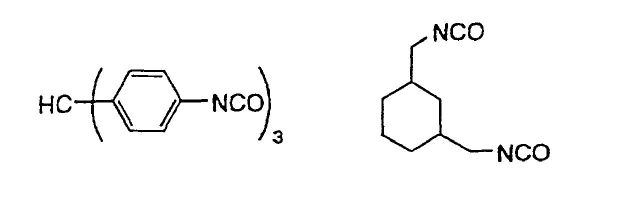

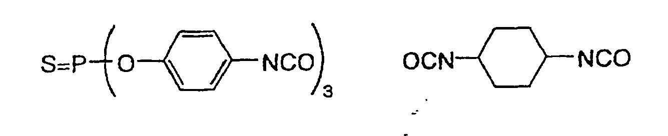

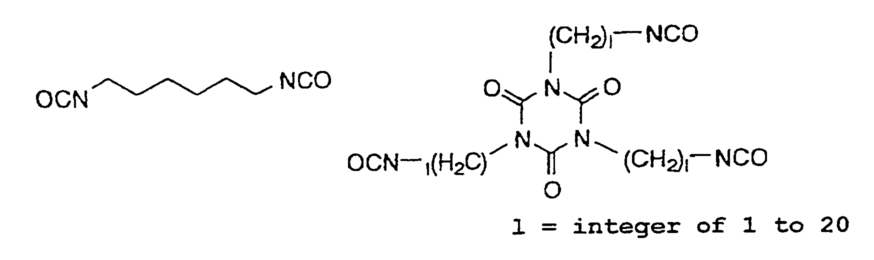

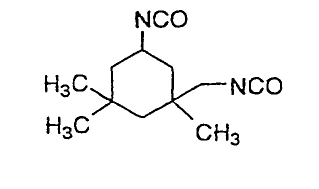

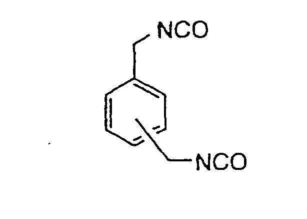

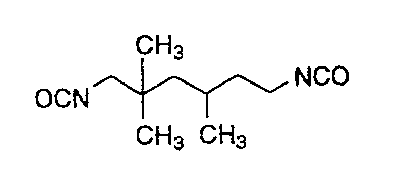

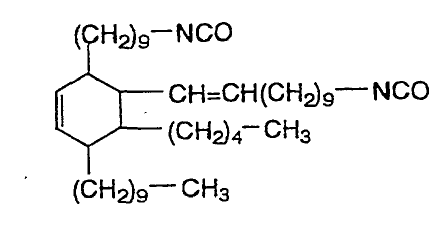

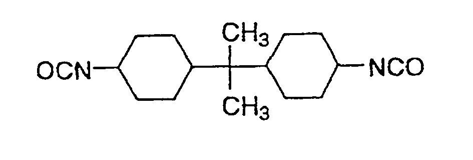

Examples of an alcohol represented by formula (II) are illustrated below: 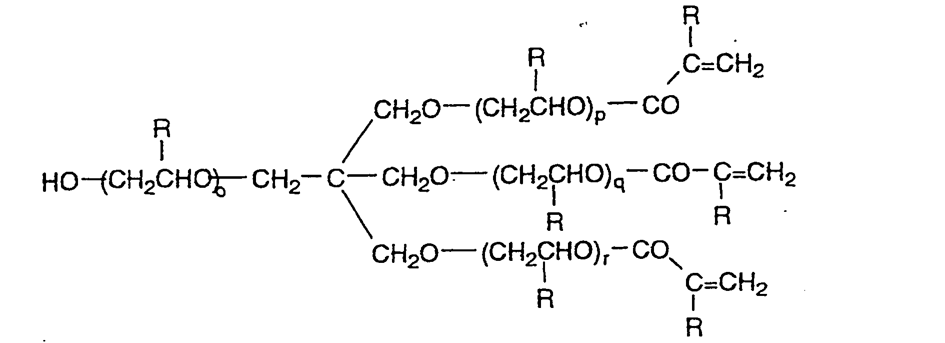 R = hydrogen or methyl group
o, p, q, r, s, t = rational number of from 0 to 20

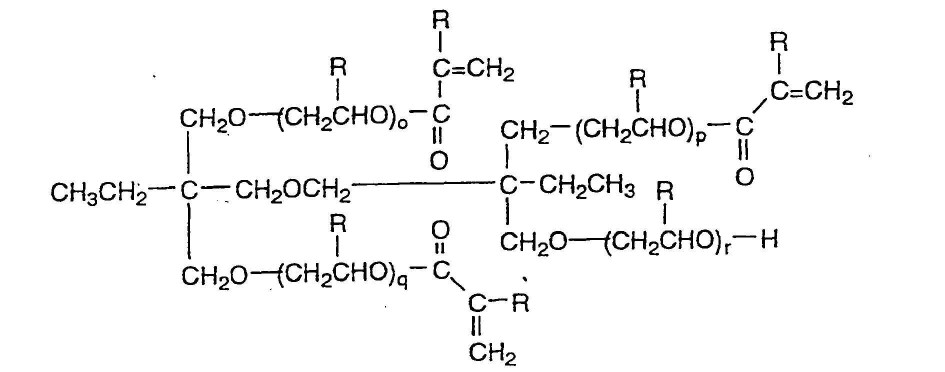

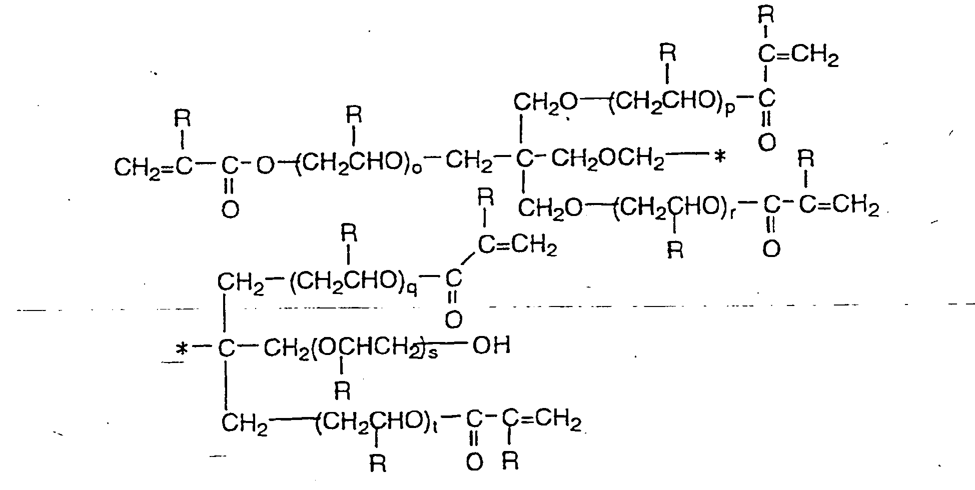

These addition polymerizable monomers having ethylenically unsatutated bond-containing alkylene oxide groups and urethane linkages are used in a proportion of from 5 to 95 % by weight (hereinafter abbreviated as "%"), preferably from 10 to 90 %, to the total ingredients in the photo polymerizable layer of the present lithographic printing plate precursor.
(ii) Addition polymerizable monomers represented by the following formula (IV): 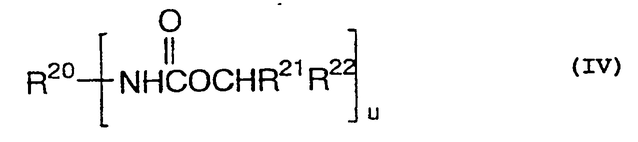 wherein R²⁰ represents -(CH₂)ᵥ-, or an unsubstituted or substituted aromatic, heteroocyclic or alicyclic group; R21 represents 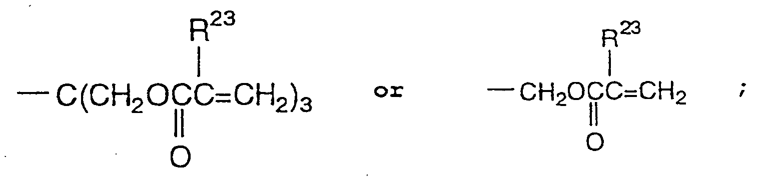 R²² represents 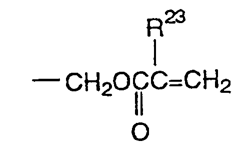 or a hydrogen atom; R23 represents a hydrogen atom or a methyl group; and u and v each represent a number of 1 or more.

In additional polymerizable monomers represented by formula (IV), R²⁰ may be any group so far as it fits the foregoing definition. However, the following are preferred as R²⁰:

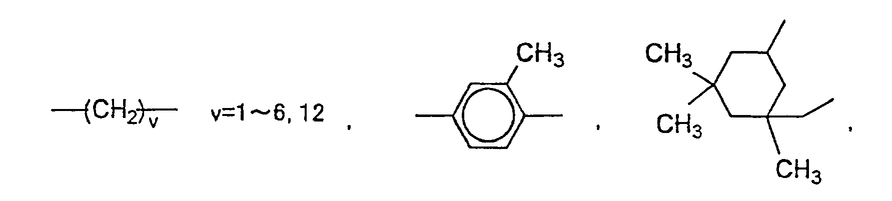

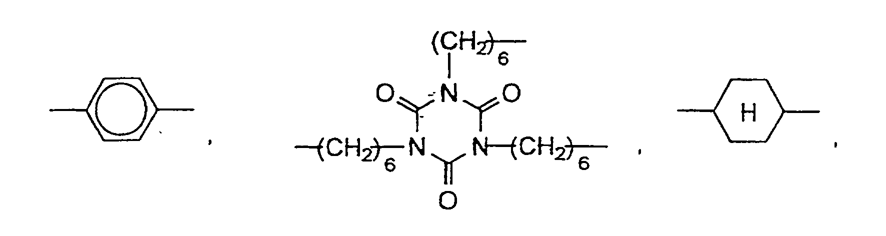

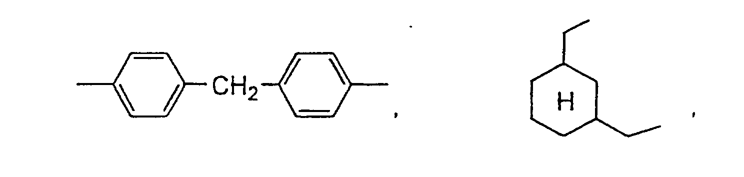

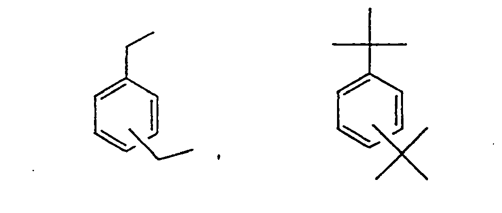

Additionally, the addition polymerizable monomers represented by formula (IV) are used in a proportion of from 5 to 95 % by weight (hereinafter abbreviated as "%"), preferably from 10 to 90 %, to the all ingredients in the photo polymerizable layer of the present lithographic printing plate precursor.

In addition to (i) addition polymerizable monomers having ethylenically unsaturated double bond-containing alkylene oxide groups and urethane linkages and (ii) addition polymerizable monomers represented by formula (IV), any of compounds having at least one (preferably at least two), of terminal ethylenically unsaturated double bond may be incorporated in the photo polymerizable layer.

For instance, those compounds may have any of chemical forms, such as a monomer, a prepolymer including a dimer, a trimer and an oligomer, a mixture of two or more thereof, and a copolymer thereof.

Examples of the compounds having the monomer form (hereinafter abbreviated as "monomeric compounds") include esters of unsaturated carboxylic acids (e.g., acrylic acid, methacrylic acid, itaconic acid, crotonic acid, isocrotonic acid, maleic acid) and aliphatic polyhydric alcohols, and amides of unsaturated carboxylic acids and aliphatic polyamine compounds. And examples of the compounds having the copolymer form include compounds obtained by polymerizing two or more different species of the monomeric compounds described above.

Examples of monomeric esters prepared from aliphatic polyhydric alcohols and unsaturated carboxylic acids include acrylic acid esters, such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl)ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sosrbitol hexaacrylate, tri(acryloyloxyethyl) isocyanurate, and polyester acrylate oligomer; methacrylic acid esters, such as tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)-phenyl]dimethylmethane and bis[p-(methacryloxyethoxy)-phenyl]dimethylmethane; itaconic acid esters, such as ethylene glycol diitaconate, propylene glycol diitaconate, 1,3-butanediol diitaconate, 1,4-butanediol diitaconate, tetramethylene glycol diitaconate, pentaerythritol diitaconatae and sorbitol tetraitaconate; crotonic acid esters, such as ethylene glycol dicrotonate, tetramethylene glycol dicrotonate, pentaerythritol dicrotonate and sorbitol dicrotonate; isocrotonic acid esters, such as ethylene glycol diisocrotonate, pentaerythritol diisocrotonate and sorbitol tetraisocrotonate; meleic acid esters, such as ethylene glycol dimaleate, triethylene glycol dimaleate, pentaerythritol dimalate and sorbitol tetramaleate; and mixtures of two or more of the esters described above.

Examples of monomeric amides prepared from aliphatic polyamine compounds and unsaturated carboxylic acids include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide and xylylenebismethacrylamide.

As examples of other addition polymerizable monomers, vinylurethane compounds having at least two polymerizable vinyl groups per one molecule which are prepared by addition of hydroxyl group-containing vinyl monomers represented by the following formula (A) to the polyisocyanate compounds having at least two isocyanate groups per molecule as disclosed in JP-B-48-41708 are exemplified:

CH₂=C(Q¹)COOCH₂CH(Q²)OH (A)

wherein Q¹ and Q² independently represent H or CH₃.

In addition to the addition polymerizable monomers described above, the urethaneacrylates disclosed in JP-A-51-37193, the polyester acrylates as disclosed in JP-A-48-64183, JP-B-49-43191 and JP-B-52-30490, and polyfunctional acrylates or methacrylates, such as epoxy acrylates prepared by reaction of epoxy resin with acrylic acid or methacrylic acid, can be employed. Further, the compounds reported as photocurable monomers and oligomers in Nippon Secchaku Kyokai Shi (Journal of Japanese Adhesive Society), vol. 20, No. 7, pp. 300-308 (1984) can also be used.

Those addition polymerizable monomers, other than (i) addition polymerizable monomers having ethylenically unsaturated double bond-containing alkylene oxide groups and urethane linkages and (ii) addition polymerizable monomers represented by formula (IV), can be used in a proportion of 5 to 90 % be weight (hereinafter abbreviated as "%"), preferably 10 to 80 %, to the total ingredients in the photo polymerizable layer of the present lithographic printing plate precursor.

### [Photo Polymerization Initiator]

Then, the thirdly important constituent in the present lithographic printing plate precursor, namely a photo polymerization initiator, is illustrated below.

The photo polymerization initiator incorporated in the photo polymerizable layer of the present lithographic printing plate precursor depends on the wavelengths of a light source used and can be selected properly from various photo polymerization initiators well-known in the patent specifications and the literature, or well-known combinations of two or more different photo polymerization initiators (photo polymerization initiator systems). Additionally, the photo polymerization initiators used independently and those used in combination are collectively referred to as photo polymerization initiator or photo initiator in the present invention.

For instance, in the case of using light of wavelengths around 400 nm as a light source, benzil, benzoyl ether, Michler's ketone, anthraquinone, thioxanthone, acridine, phenazine and benzophenone have been widely used as photo initiator.

In other cases also, wherein visible rays having wavelengths of 400 nm or longer, Ar laser, secondary harmonic waves of semiconductor lasers or SHG-YAG laser is used as a light source, various photo initiators have been reported. Examples of such photo initiators include certain photoreducible dyes disclosed in U.S. Patent 2,850,445, such as Rose Bengal, Eosine and erythrosine; and the combinations of dyes and photo initiators, such as the complex initiators of dyes and amines (JP-B-44-20189), the combinations of hexaarylbiimidazoles, radical generators and dyes (JP-B-45-37377), the combinations of hexaarylbiimidazoles and p-dialkylaminobenzylideneketones (JP-B-47-2528 and JP-A-54-155292), the combinations of cyclic cis-α-dicarbonyl compounds and dyes (JP-A-48-84183), the combinations of cyclic triazines and merocyanine dyes (JP-A-54-151024), the combinations of 3-ketocoumarin and activators (JP-A-52-112681 and JP-A-58-15503), the combinations of biimidazole, styrene derivatives and thiols (JP-A-59-140203), the combinations of organic peroxides and dyes (JP-A-59-1504, JP-A-59-140203, JP-A-59-189340, JP-A-62-174203, JP-B-62-1641 and U.S. Patent 4,766,055), the combinations of dyes and active halogen compounds (JP-A-63-178105, JP-A-63-258903 and JP-A-2-63054), the combinations of dyes and borate compounds (JP-A-62-143044, JP-A-62-150242, JP-A-64-13140, JP-A-64-13141, JP-A-64-13142, JP-A-64-13143, JP-A-64-13144, JP-A-64-17048, JP-A-1-229003, JP-A-1-298348 and JP-A-1-138204), the combinations of rhodanine ring-containing dyes and radical generators (JP-A-2-179643 and JP-A-2-244050), the combinations of titanocene and 3-ketocoumarin dyes (JP-A-63-221110), the combinations of titanocene, xanthene dyes and addition polymerizable ethylenically unsaturated compounds having amino or urethane groups (JP-A-4-221958 and JP-A-4-219756), the combinations of titanocene and specified merocyanine dyes (JP-A-6-295061) and the combinations of titanocene and benzopyran ring-containing dyes (JP-A-7-164583).

Of these photo initiators, the dye-initiator combinations wherein the dyes used are cyanine, merocyanine, xanthene, ketocoumarin or benzopyran dyes and the initiator used are titanocene or triazine compounds are preferred over the others.

The cyanine dyes suitable for the foregoing combinations are those having the structure illustrated below, but the present invention should not be construed as limiting them to particular ones: 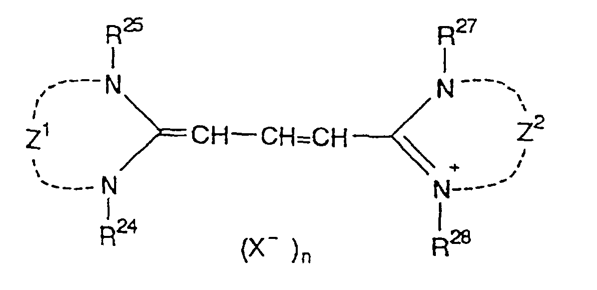 (wherein Z¹ and Z², which may be the same or different, each represent nonmetal atoms necessary for completing a benzimidazole or naphthoimidazole ring, R²⁴, R²⁵, R²⁶ and R²⁷ each represent an unsubstituted or substituted alkyl group, X represents a counter anion, and n is 0 or 1).

Examples of such cyanine dyes are shown in Table 1.

**Table 1**

| | | | | | | | | | |
|---|---|---|---|---|---|---|---|---|---|
| 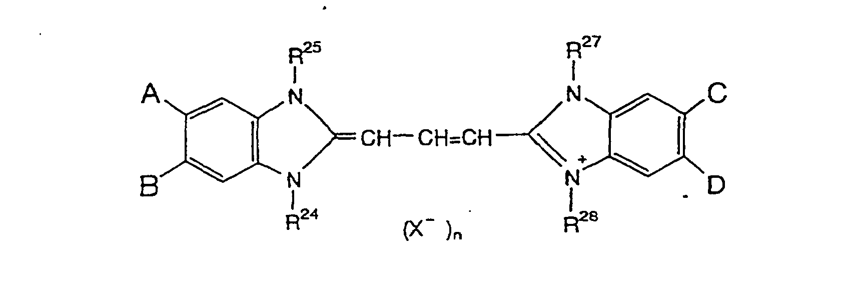 | | | | | | | | | |

| R²⁴ | R²⁵ | R²⁶ | R²⁷ | A | B | C | D | X⁻ | n |
|---|---|---|---|---|---|---|---|---|---|
| C₂H₅ | C₂H₅ | C₂H₅ | C₂H₅ | Cl | Cl | Cl | Cl | I⁻ | 1 |
| C₂H₅ | C₂I3₅ | C₂H₅ | C₂H₅ | H | CF₃ | H | CF₃ | I⁻ | 1 |
| (CH₂)₂SO₃Na | C₂H₅ | (CH₂)₂SO₃⁻ | C₂H₅ | Cl | Cl | Cl | Cl | - | 0 |

The merocyanine dyes suitable for the foregoing combinations include those respectively having the two different structures illustrated below, but the present invention should not be construed as limiting them to particular ones: 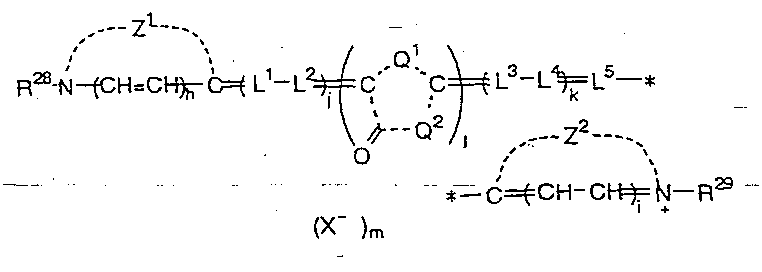 (wherein Z¹ and Z² each represent nonmetal atoms necessary for completing a 5- and/or 6-membered nitrogen-containing hetero ring generally present in cyanine dyes, R²⁸ and R²⁹ each represent an alkyl grouip, Q¹ and Q² are atoms necessary for completing 4-thiazolidinone, 5-thiazolidinone, 4-imidazolidinone, 4-oxazolidinone, 5-oxazolidinone, 5-imidazolidinone or 4-dithiolanone ring with collaboration, L¹, L², L³, L⁴ and L⁵ each represent a methine group, m is 1 or 2, i and h are each 0 or 1, λ is 1 or 2, j and k are each 0, 1, 2 or 3, and X⁻ represents a counter anion) 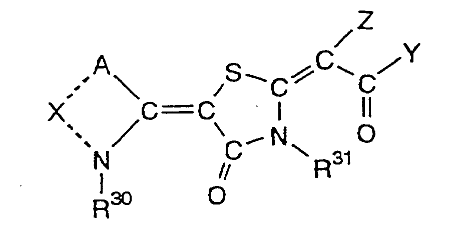 (wherein R³⁰ and R³¹ independently represent a hydrogen atom, an alkyl group, a substituted alkyl group, an alkenyl group, a substituted alkenyl group, an alkynyl group, a substituted alkynyl group, an alkoxycarbonyl group, an aryl group, a substituted aryl group or an aralkyl group; A represents an oxygen atom, a sulfur atom, a selenium atom, a tellurium atom, an alkyl- or aryl-substituted nitrogen atom, or a dialkylsubstituted carbon atom; X represents nonmetal atoms necessary for completing a nitrogen-containing 5-membered hetero ring; Y represents a substituted phenyl group, an unsubstituted or substituted polynuclear aromatic ring, or an unsubstituted or substituted aromatic hetero ring; and Z represents a hydrogen atom, an alkyl group, a substituted alkyl group, an aryl group, a substituted aryl group, an aralkyl group, an alkoxy group, an alkylthio group, an arylthio group, a substituted amino group, an acyl group or an alkoxycarbonyl group, or Z may combine with Y to form a ring).

Examples of such merocyanine dyes are illustrated below:

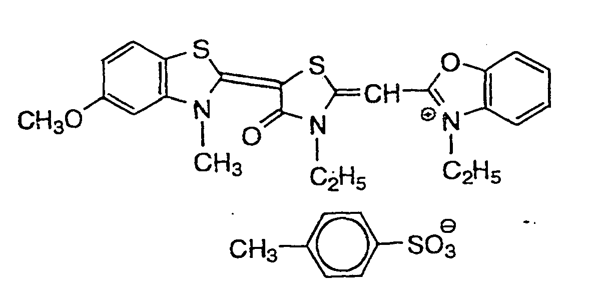

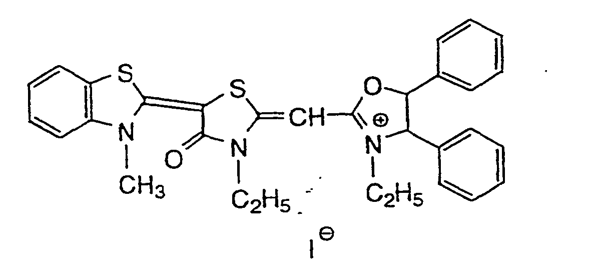

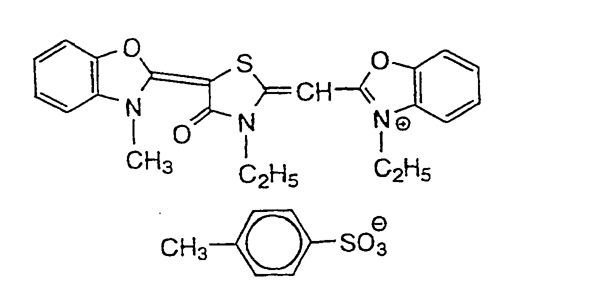

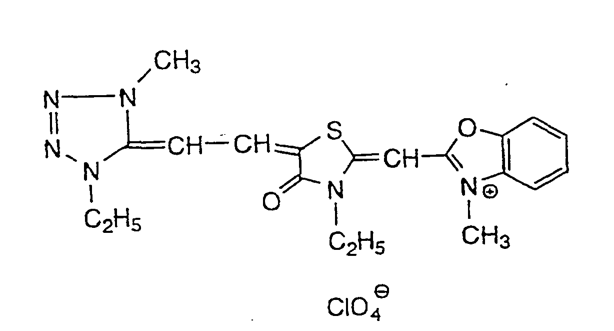

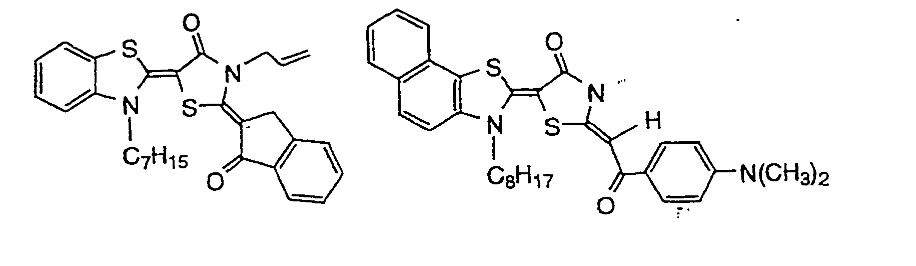

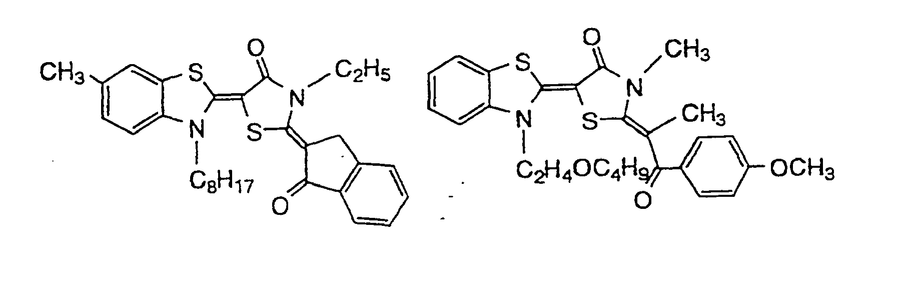

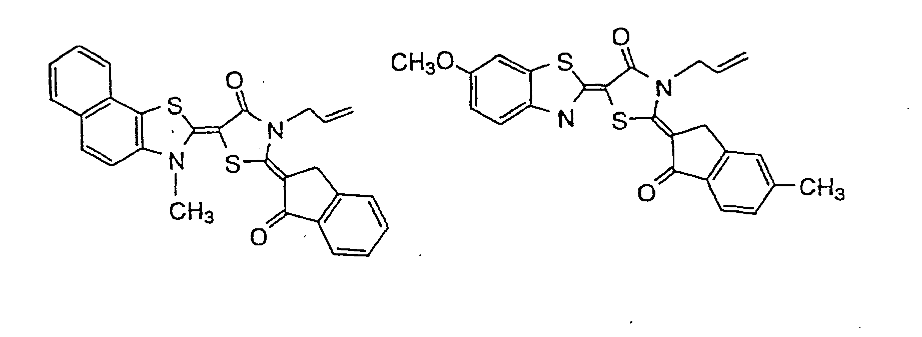

Examples of xanthene dyes suitable for the foregoing combinations include Rhodamine B, Rhodamine 6G, ethyl eosine, alcohol-soluble eosine, Pyronine Y and Pyronine B.

The ketocoumarin dyes suitable for the foregoing combinations are those having the structure illustrated below, but the present invention should not be construed as limiting them to particular ones: 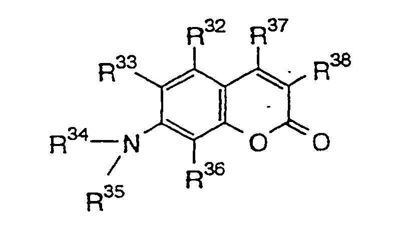 wherein R³², R³³ and R³⁶ each represent a hydrogen atom, a halogen atom, an alkyl group or an alkoxy group, and R³⁴ and R³⁵ each represent an alkyl group, provided that at least of them is an alkyl group with 4 to 16 carbon atoms, or R³³ and R³⁴, or R³⁵ and R³⁶ combine with each other to form a ring; R³⁷ represents a hydrogen atom, an alkyl group, an alkoxy group, an acyl group, a cyano group, a carboxyl group, or an ester or amide derivative of the carboxylic acid; R³⁸ represents a hetero ring residue with 3 to 17 carbon atoms or -CO-R³⁹; and R³⁹ represents an alkoxy group or a group illustrated below:

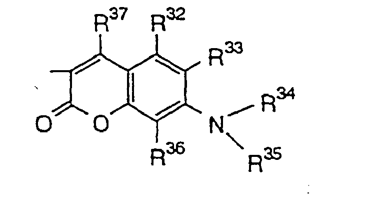

Examples of such ketocoumarin dyes are illustrated below:

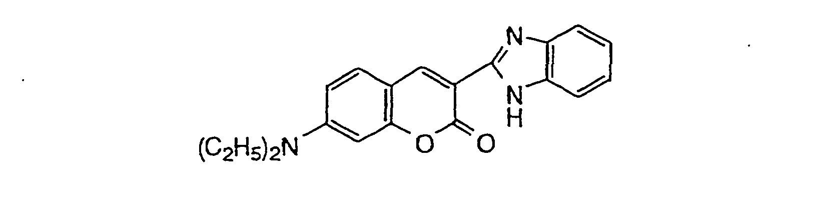

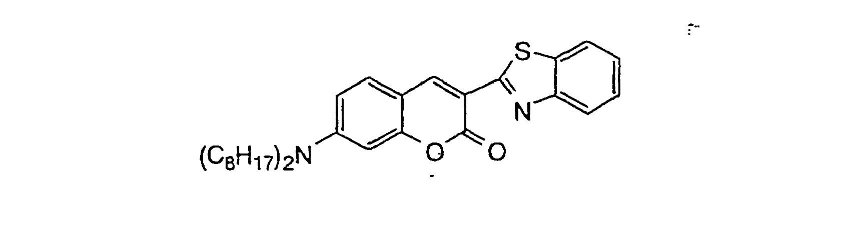

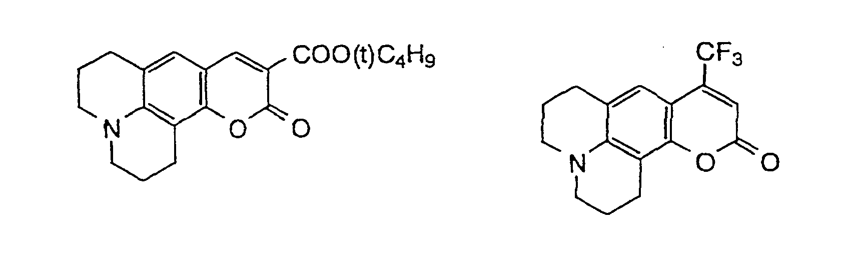

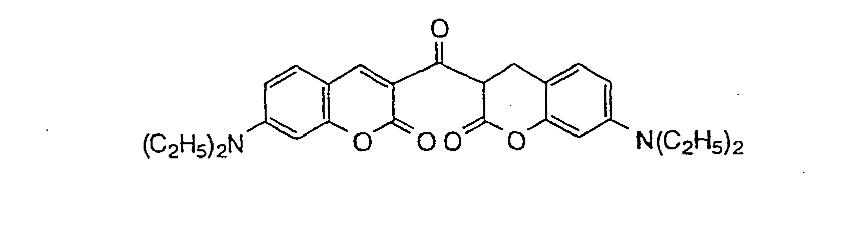

The benzopyran dyes suitable for the foregoing combinations are those having the structure illustrated below, but the present invention should not be construed as limiting them to particular ones: 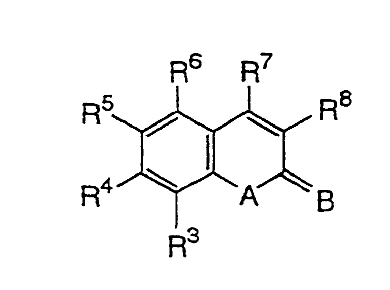 wherein R³ to R⁶ independently represent a hydrogen atom, a halogen atom, an alkyl group, an aryl group, a hydroxyl group, an alkoxy group or an amino group, or R³ to R⁶ each may form a ring constituted of nonmetal atoms in cooperation with the carbon atom with which they can each combine; R⁷ represents a hydrogen atom, an alkyl group, an aryl group, an aromatic heterocyclic group, a cyano group, an alkoxy group, a carboxyl group or an alkenyl group; R⁸ represents a group represented by R⁷ or -Z-R⁷; Z represents a carbonyl group, a sulfonyl group, a sulfinyl group or an arylenedicarbonyl group; or R⁷ and R⁸ may combine with each other to form a ring constituted of nonmetal atoms; A represents O,S-, NH or a nitrogen atom having a substituent; and B is a group of formula, 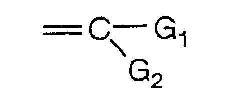 (wherein G¹ and G², which may be the same or different, each represent a hydrogen atom, a cyano group, an alkoxycarbonyl group, an aryloxycarbonyl group, an acyl group, an arylcarbonyl group, an alkylthio group, an arylthio group, an alkylsulfonyl group, an arylsulfonyl group or a fluorosulonyl group, provided that the case of G¹=G²=H is excluded, or G¹ and G² may combine with each other to form a metal-free ring together with the carbon atom).

Examples of such benzopyran dyes are illustrated below:

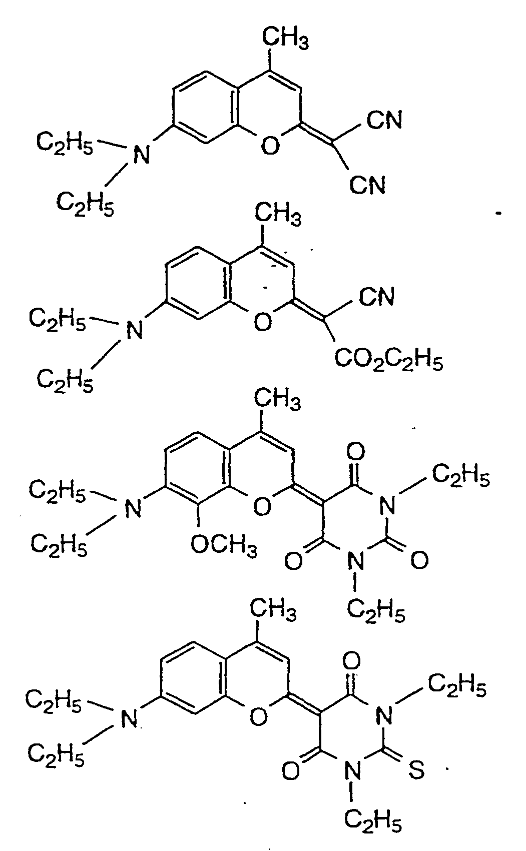

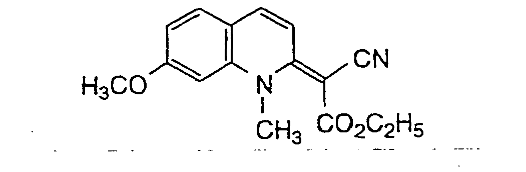

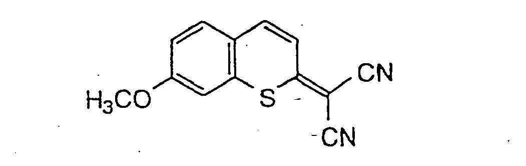

Triazine compounds preferred as the photo initiator are those represented by the following formula: 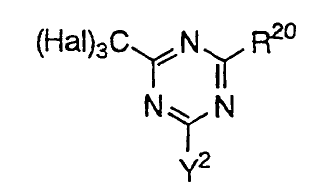 wherein Hal represents a halogen atom, Y² represents -C(Hal)₃, -NH₂, -NHR²¹, -N(R²¹)₂ or -OR²¹, R²¹ represents an alkyl group, a substituted alkyl group, an aryl group or a substituted aryl group, and R²⁰ represents -C(Hal)₃, an alkyl group, a substituted alkyl group, an aryl group, a substituted aryl group or a substituted alkenyl group.

Examples of such triazine compounds are illustrated below:

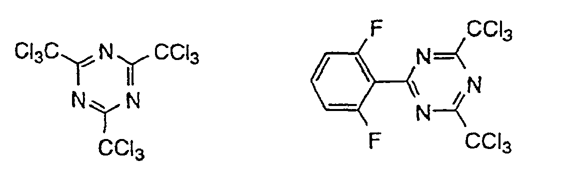

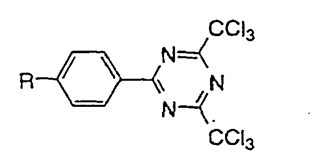

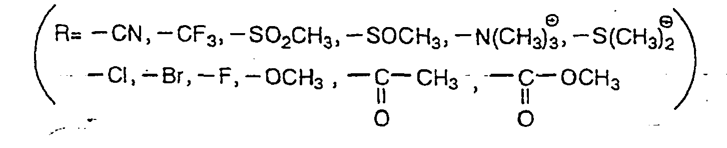

Titanocene compounds which are also preferred as the photo initiator can be selected properly from the compounds as disclosed in JP-A-59-152396 and JP-A-1-151197.

As examples of such titanocene compounds, mention may dicyclopentadienyl-Ti-dichloride, dicyclopentadienyl-Ti-bisphenyl, dicyclopentadienyl-Ti-bis-2,3,4,5,6-pentafluorophen-1-yl (hereinafter referred to as "A-1"), dicyclopentadienyl-Ti-bis-2,3,5,6-tetrafluorophen-1-yl, dicyclopentadienyl-Ti-bis-2,4,6-trifluorophen-1-yl, dicyclopentadienyl-Ti-bis-2,6-difluorophen-1-yl, dicyclopentadienyl-Ti-bis-2,4-difluorophen-1-yl, di-methylcyclo-pentadienyl-Ti-bis-2,3,4,5,6-pentafluorophen-1-yl (hereinafter referred to as "A-2"), di-methylcyclo-pentadienyl-Ti-bis-2,3,5,6-tetrafluorophen-1-yl, di-methylcyclopentadienyl-Ti-bis-2,4-difluorophen-1-yl, and dis(cyclopentadienyl)-bis(2,6-difluoro-3-(pyri-1-yl)phenyl) titanium (hereinafter referred to as "A-3") are exemplified.

In the photo polymerizable layer of the present lithographic printing plate precursor, those photo polymerization initiators are generally incorporated in a small proportion. When they are present in an unsuitably large proportion, they bring about undesirable results, such as cut in effective rays. The suitable proportion of photo polymerization initiators is from 0.01 to 70 % by weight, preferably from 1 to 50 % by weight, to the sum total of the binder component and the addition polymerizable monomer component.

In addition, auxiliary agents of initiators, such as amine compounds and thiol compounds, may be added to the photo polymerizable layer. In particular, amine compounds and amino acids represented by the following formulae are preferred as the auxiliary agents: 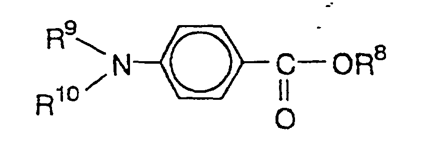 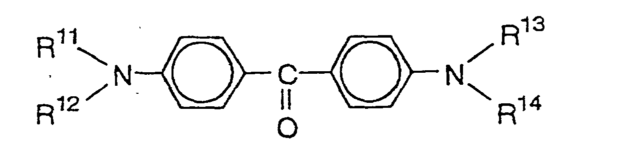 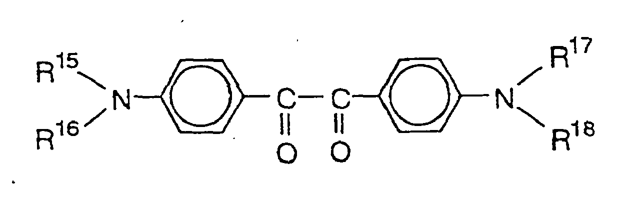 (wherein R⁸ to R¹⁸ each represent an alkyl group) 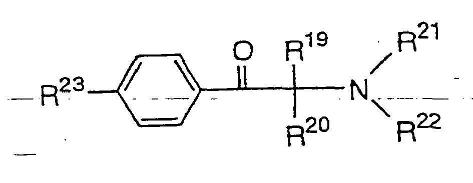 (wherein R¹⁹ to R²² each represent an alkyl group or an alkoxy group, and R²¹ and R²² may combine with each other to form a ring; and R23 represents a heterocyclic group or an alkylthio group) 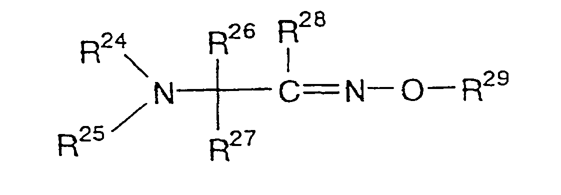 (wherein R²⁸ and R²⁹, which are the same or different, each represent an unsubstituted or substituted hydrocarbon group which may contain an unsaturated bond, or a heterocyclic group; R²⁶ and R²⁷, which are the same or different, each represent a hydrogen atom, an unsubstituted or substituted hydrocarbon group which may contain an unsaturated bond, a heterocyclic group, a hydroxyl group, a substituted oxy group, a mercapto group or a substituted thio group, or R²⁶ and R²⁷ are alkylene groups with 2 to 8 carbon atoms which combine with each other to form a ring the main linkage of which may contain -O- , -NR²⁴, -O-CO-, -NH-CO-, -S- or/and -SO₂-; and R24 and R25 each represent a hydrogen atom, an unsubstituted or substituted hydrocarbon group which may contain an unsaturated bond, or a substituted carbonyl group).

In addition to the compounds illustrated above, examples of auxiliary agents used to advantage include dialkylbenzoic acid esters such as ethyl p-diethylaminobenzoate, bisaminobenzophenones such as 4,4'-bis(dimethylamino)benzophenone, bisaminobenzyls such as 4,4'-bis(diethylamino)benzyl, the amine compounds illustrated below, 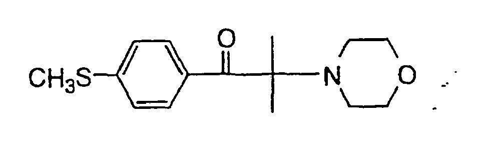 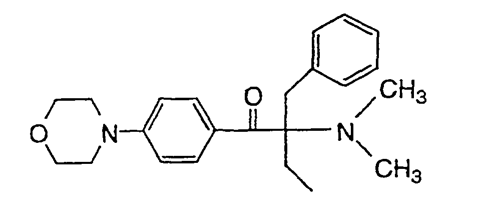 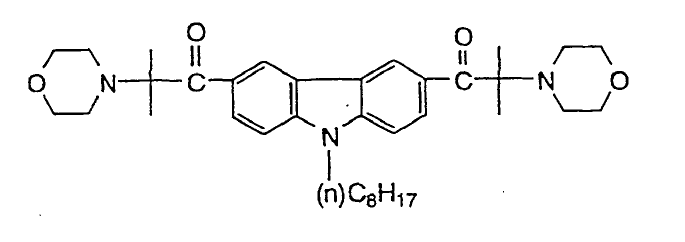 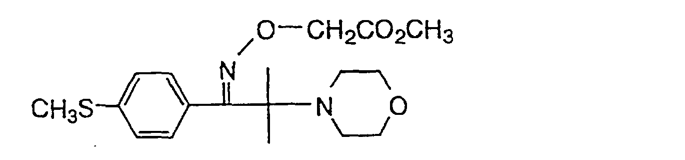 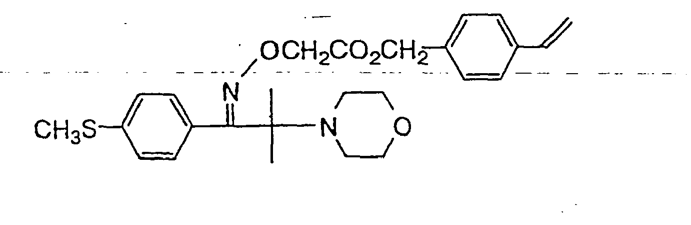 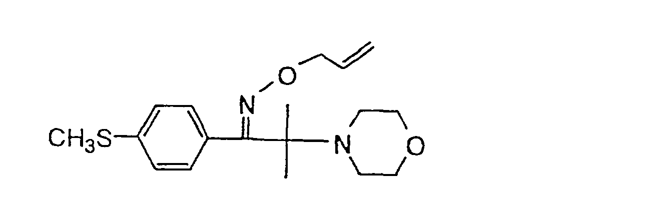 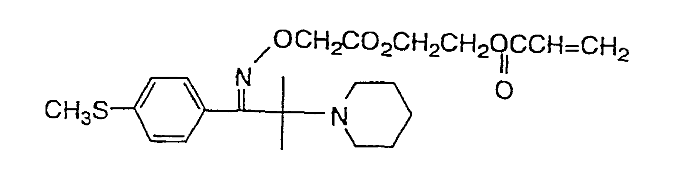 N-phenylglycine and sodium N-phenylglycine.

In addition to the basic components mentioned above, a small amount of thermal polymerization inhibitor is preferably added to a composition for the photo polymerizable layer with the intention of preventing the addition polymerizable monomers from undergoing unnecessary thermal polymerization during the preparation or storage of the composition. Suitable examples of a thermal polymerization inhibitor include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), N-nitrosophenylhydroxylamine cerium salt, and N-nitrosophenylhydroxylamine aluminum salt.

Preferably, such thermal polymerization initiators are added in a proportion of about 0.01 to about 5 % by weight to the total ingredients in the composition for the photo polymerizable layer of the present lithographic printing plate precursor. In addition, higher fatty acids or derivatives thereof, such as behenic acid or behenic acid amide, may be added to the composition and localized on the surface of the photo polymerizable layer during the drying process after coating, if needed for preventing the polymerization hindrance due to oxygen. Preferably, such higher fatty acid derivatives are added in a proportion of about 0.5 to about 10 % by weight to the total ingredients in the composition for the photo polymerizable layer of the present lithographic printing plate precursor.

Further, coloring agents may be added to the composition for the purpose of coloring the photo polymerizable layer. Examples of such coloring agents include pigments, such as phthalocyanine pigments (C.I. Pigment Blue 15:3, 15:4, 15:6), azo pigments, carbon black and titanium dioxide; and dyes, such as Ethyl Violet, Crystal Violet, azo dyes, anthraquinone dyes and cyanine dyes. Preferably, these dyes and pigments are added in a proportion of about 0.5 to about 5 % by weight to the total ingredients in the composition for the photo polymerizable layer of the present lithographic printing plate precursor.

In addition, other additives, including inorganic fillers and plasticizers, such as dioctyl phthalate, dimethyl phthalate and tricresyl phosphate, may be added to the composition for the purpose of improving the physical properties of the cured film. Preferably, these additives are added in a proportion of at 10 % by weight or less to the total ingredients in the composition for the photo polymerizable layer of the present lithographic printing plate precursor.

Furthermore, surfactants can be added to the composition for the photo polymerizable layer of the present lithographic printing plate precursor for the purpose of improving properties of the coating surface.

In coating a substrate with the photo polymerizable layer, the ingredients to constitute the layer is dissolved in an organic solvent and used as a solution. Examples of an organic solvent usable therein include a wide variety of solvents, such as acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, prolylene glycol monoethyl ether acetate, 3-methoxypropyl-acetate, N,N-dimethylformamide, dimethyl sulfoxide, γ-butyrolactone, methyl lactate, and ethyl lactate. These solvents can be used alone or as combination of two or more thereof.

The suitable solid component concentration in the coating solution is from 1 to 50 % by weight.

The suitable coverage of the photo polymerizable layer in the present lithographic printing plate precursor is from about 0.1 to about 10 g/m², preferably from 0.3 to 5 g/m², particularly preferably from 0.5 to 3 g/m², on a dry weight basis.

As a substrate of the present lithographic printing plate precursor, dimensionally stable sheet or plate-form materials are usable. Examples of such materials include paper, paper laminated with plastics (e.g., polyethylene, polypropylene, polystyrene), a metal sheet (e.g., a sheet of aluminum (including aluminum alloys), zinc or copper), a plastic film (e.g., a film of cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal), and paper or a plastic film on which the metal as described above is laminated or deposited, are exemplified. Of these materials, aluminum sheets are preferred as the substrate used in the present invention because of their very high dimensional stability and low-price. Further, the composite sheet made up of polyethylene terephthalate film and an aluminum sheet bound thereon as disclosed in JP-B-48-18327 is also used to advantage.

When the substrate having a metal surface, especially an aluminum surface, is employed, it is desirable that the substrate be subjected in advance to surface treatment, such as graining treatment, immersion treatment in an aqueous solution of sodium silicate, potassium fluorozirconate or a phosphate or anodic oxidation treatment.

Another material suitable as the substrate used in the present invention is an aluminum sheet having undergone immersion treatment in a water solution of sodium silicate after graining treatment. Still another material suitable as the substrate used in the present invention is an aluminum sheet having undergone immersion treatment in a water solution of alkali metal silicate after anodic oxidation treatment. The anodic oxidation treatment is carried out by applying an electric current to the aluminum sheet used as an anode in an electrolyte, such as an aqueous or non-aqueous solution of inorganic acid (e.g., phosphoric acid, chromic acid, sulfuric acid, boric acid), organic acid (e.g., oxalic acid, sulfaminic acid) or salt thereof, or a combination of two or more of such solutions.

Further, it is also effective to subject an aluminum sheet to the electrodeposition of silicate as disclosed in U.S. Patent 3,658,662.

Furthermore, the substrate having undergone the combined surface treatment of the anodic oxidation as mentioned above and sodium silicate treatment after electrolytic graining as disclosed in JP-A-46-27481, JP-A-52-58602 and JP-A-52-30503 is useful.

In addition, the substrate having undergone sequentially mechanical graining, chemical etching, electrolytic graining, anodic oxidation treatmntand sodium silicate treatment, as disclosed in JP-A-56-28893, is also suitable as the present substrate.

After these treatments, it is favorable that the substrate be undercoated with a water-soluble resin, such as polyvinyl phosphonic acid, a homo- or copolymer having sulfonic acid groups in its side chains or polyacrylic acid, a water-soluble metal salt (e.g., zinc borate), a yellow dye or amine salt.

Further, the sol-gel treated substrate as disclosed in JP-A-7-159983, wherein functional groups capable of causing addition reaction by radicals are covalently bonded, is suitably used.

Those water receptivity-imparting treatments are given to the substrate for not only rendering the substrate surface water-receptive but also protecting compositions of the photo polymerizable layer provided thereon from harmful reactions, and besides, for improving its adhesion to the photo polymerizable layer.

On the photo polymerizable layer provided on the substrate, a protective layer comprising a polymer highly impervious to oxygen, such as polyvinyl alcohol, polyvinyl pyrrolidone or acid cellulose, may be formed for the purpose of preventing inhibition of the polymerization due to the oxygen in the air. The coating methods for such a protective layer are described in detail, e.g., in U.S. Patent 3,458,311 and JP-A-55-49729.

The lithographic printing plate precursor prepared by coating the photo polymerizable layer on the substrate as described above is exposed directly to beams from, e.g., Ar laser or YAG-SHG laser.

After imagewise exposure, the printing plate precursor is subjected to development. In the development, conventional aqueous alkali solutions can be used as developer. Examples of alkali agents used therein include inorganic alkalis, such as sodium silicate, potassium silicate, sodium tertiary phosphate, potassium tertiary phosphate, ammonium tertiary phosphate, sodium secondary phosphate, potassium secondary phosphate, ammonium secondary phosphate, sodium carbonate, potassium carbonate, ammonium carbonate, sodium hydrogen carbonate, potassium hydrogen carbonate, ammonium hydrogen carbonate, sodium borate, potassium borate, ammonium borate, sodium hydroxide, ammonium hydroxide, potassium hydroxide and lithium hydroxide, and organic alkalis, such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine and pyridine.

These alkali agents may be used alone, or as a combination of two or more thereof.

Of the aqueous alkali solutions described above, the aqueous solutions containing alkali metal silicates and having a pH value of at least 12 are advantageous over the others, because they can further increase the effects of the present plate precursor. In the case of using an aqueous solution of alkali metal silicate, the developability thereof can be controlled by properly choosing the molar ratio of silicon oxide SiO₂ to alkali metal oxide M₂O in the silicate (generally described as [SiO₂]/[M₂O]) and the silicate concentration. For instance, the aqueous solution of sodium silicate disclosed in JP-A-54-62004, wherein the molar ratio of SiO₂ to Na₂O is from 1.0 to 1.5 (or [SiO₂]/[Na₂O] = 1.0 to 1.5) and the SiO₂ concentration is from 1 to 4 % by weight, and the aqueous solution of alkali metal silicate disclosed in JP-B-57-7427, wherein the [SiO₂]/[M] ratio is from 0.5 to 0.75 (or [SiO₂]/[M₂O] = 1.0 to 1.5), the SiO₂ concentration is from 1 to 4 % by weight and potassium is contained in a proportion of at least 20 % to the total alkali metals on a gram-atomic basis, can be used to advantage.

Further, in the case of developing lithographic printing plate precursors by use of an automatic developing machine, it is well-known that the addition of a solution having higher alkalinity (a replenisher) to the developer enables a great quantity of plate precursors to be processed without replacing the developer in the developing tank over a long period. This replenishing method can be applied favorably to the present invention. As examples of a developing method suitable for the present invention, the method disclosed in JP-A-54-62004 which comprises using as a developer an aqueous sodium silicate solution having a molar ratio of SiO₂ to Na₂O in the range of 1.0 to 1.5 (or [SiO₂]/[Na₂O] of 1.0 to 1.5) and a SiO₂ concentration in the range of 1 to 4 % by weight and adding continuously or intermittently to the developer an aqueous sodium silicate solution (replenisher) having a molar ratio of SiO₂ to Na₂O in the range of 0.5 to 1.5 (or [SiO₂]/ [Na₂O] of 0.5 to 1.5) in an amount depending on the processing throughput of negative lithographic printing plate precursors, and the developing method disclosed in JP-B-57-7427 which comprises using as a developer an aqueous solution of alkali metal silicate having [SiO₂]/[M] in the range of 0.5 to 0.75 (or [SiO₂]/[M₂O] of 1.0 to 1.5) and a SiO₂ concentration of 1 to 4 % by weight, and besides, using as a replenisher an aqueous solution of alkali metal silicate having [SiO₂]/[M] in the range of 0.25 to 0.75 (or [SiO₂]/[M₂O] of 0.5 to 1.5), with both developer and replenisher containing potassium in a proportion of at least 20 % to the total alkali metals on a gram-atomic basis are exemplified.

The thus development-processed lithographic printing plates are further treated with successive washing water, a rinsing solution containing surfactants and a desensitizing solution containing gum arabic or a starch derivative, as disclosed in JP-A-54-8002, JP-A-55-115045 and JP-A-59-58431. For the after-treatment of the lithographic printing plate made from the present lithographic printing plate precursor, those treatments can be employed in various combinations.

The lithographic printing plate prepared by carrying out development, and then after-treatment such as the desensitizing treatment described above, if needed, and further overall exposure is loaded in an offset press, and used for printing on a great number of sheets.

As a plate cleaner for removal of stain on the plate in the course of printing, conventional plate cleaners for PS plate, such as CL-1, CL-2, CP, CN-4, CN, CG-1, PC-1, SR and IC (produced by Fuji Photo Film Co., Ltd.), can be employed. In particular, CP and CN-4 are used to advantage.

### EXAMPLE

Now, the present invention is illustrated in greater detail by reference to the following examples, but these examples should not be construed as limiting on or determinative of the scope of the present invention.

### EXAMPLES 1 TO 14, AND COMPARATIVE EXAMPLES 1 AND 2

### (Preparation of Lithographic Printing Plate Precursor)

The surface of a 0.30 mm-thick aluminum sheet was grained using a nylon brush and a 400-mesh pumice stone-water suspension, and washed thoroughly with water. This sheet was etched by 60-second immersion in a 10 % aqueous solution of sodium hydroxide kept at 70°C, washed with running water, rinsed with 20 % HNO₃ for neutralization, and further washed with water. Then, the thus etched sheet underwent electrolytic treatment for roughening the surface thereof, wherein a 1 % aqueous solution of nitric acid was used as an electrolyte and an alternating current of sine-wave form was applied under the condition of V_{A} = 12.7 V so that the quantity of electricity at the anode was 160 Coulomb/dm². The surface roughness measurement showed that the thus treated sheet had a surface roughness of 0.6 µ, expressed in terms of Ra. Successively thereto, the aluminum sheet was desmutted by 2-minute immersion in a 30 % aqueous solution of H₂SO₄ kept at 55°C, and further anodized for 2 minutes in a 20 % aqueous solution of H₂SO₄ under the condition of a current density of 2 A/dm² till the anodic oxidation film had a thickness of 2.7 g/m². Thus, a substrate was prepared.

A liquid composition (sol solution) for the sol-gel method was prepared in the following manner:

### Composition of Sol Solution:

| | |
|---|---|
| Phosmer PE (trade name, a product of Uni Chemical Co., Ltd.) | 24 parts by weight |
| Methanol | 130 parts by weight |
| Water | 20 parts by weight |
| 85 % phosphoric acid | 16 parts by weight |
| Tetraethoxysilane | 50 parts by weight |
| 3-Methacryloxypropyltrimethoxysilane | 48 parts by weight |

These ingredients were placed in a reaction vessel, and mixed with stirring. After a lapse of 5 minutes, the generation of heat was noticed. After the reaction was run for 60 minutes, the contents was transferred into another vessel, and thereto 3,000 parts by weight of methanol was added to obtain a sol solution.

The thus obtained sol solution was diluted with a methanol/ethylene glycol (9/1 by weight) mixture, coated with a whirler so that the amount of Si was 3 mg/m² on the substrate, and then dried at 100°C for 1 minute.

The thus treated substrate was coated with a photo polymerizable composition described below so as to have a dry coverage of 1.4 g/m², and then dried at 80°C for 2 minute. Thus, the photo polymerizable layer was formed.

### Photo Polymerizable Composition:

| Ingredient | Amount used |
|---|---|
| Binder selected from polymers B-1 to B-7 illustrated below | set forth in Table 2 |
| Monomer selected from addition poly-merizable monomers M-1 to M-6 illustrated below | set forth in Table 2 |
| Compound 1 illustrated below | set forth in Table 2 |
| Compound 2 illustrated below | set forth in Table 2 |
| Compound 3 illustrated below | set forth in Table 2 |
| Compound 4 illustrated below | set forth in Table 2 |
| Compound 5 illustrated below | set forth in Table 2 |
| Copper phthalocyanine Pigment Blue 15:6/(A)=3/2 dispersion [(A): a copolymer (80/20 by weight) of allylmethacrylate and methacrylic acid (molecular weight: 30,000)] | 0.5 g |
| Megafac F-177 (fluorine-containing surfactant, trade name, produced by Dai-Nippon Ink & Chemicals, Inc. | 0.02 g |
| Aluminum salt of N-nitrosophenylhydrox-ylamine (produced by Wako Pure Chemical Industries, Ltd. | 0.015 g |
| Propylene glycol monomethyl ether | 27.5 g |
| Methyl ethyl ketone | 19.0 g |

The structures of a binder and a monomer used in each composition are illustrated below:

| | | | | | | | | | |
|---|---|---|---|---|---|---|---|---|---|
| 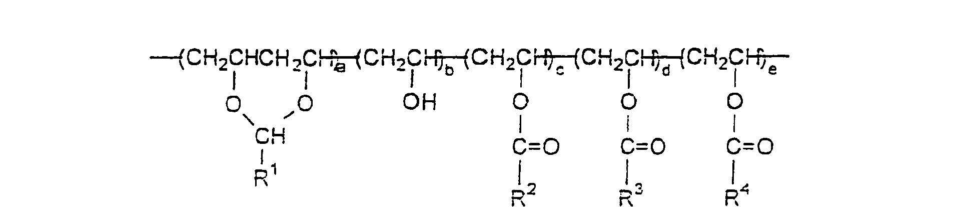 | | | | | | | | | |

| R¹ | R³ | R⁴ | R² | a | b | d | e | c | M̅w |
|---|---|---|---|---|---|---|---|---|---|
| B-1 C₃H₇ | 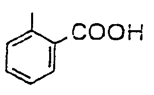 | 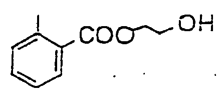 | - | 52 | 17 | 22 | 9 | 0 | 50,000 |
| B-2 " | 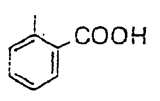 | - | CH₃ | 52 | 21 | 25 | 0 | 2 | 50,000 |
| B-3 " | 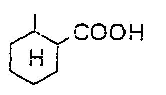 | - | CH₃ | 52 | 20 | 26 | 0 | 2 | 50,000 |
| B-4 C₂H₅ | 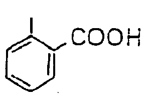 | 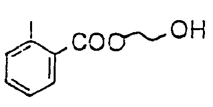 | - | 52 | 15 | 24 | 10 | 0 | 40, 000 |
| B-5 C₃H₇ | 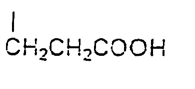 | - | CH₃ | 52 | 27 | 16 | 0 | 2 | 60,000 |
| B-6 | 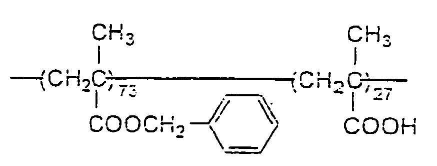 | | M̅w | | | 60,000 | | | |
| B-7 | 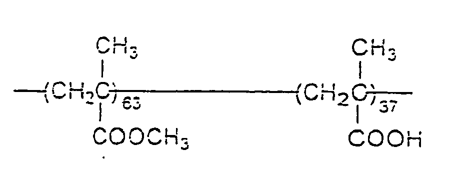 | | M̅w | | | 50,000 | | | |

M-1 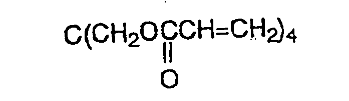
M-2
   In formula (IV) shown below, R²⁰ is -(CH_{2) 6}-, and
   R²¹ and R²² are each 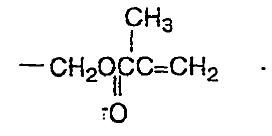
M-3
   In formula (IV) shown below, R²⁰ is -(CH₂)₆-,
   R²¹ is 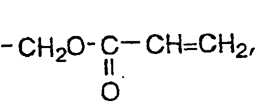 and R²² is 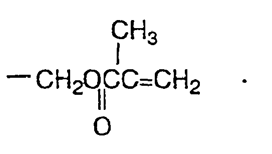
M-4 In formula (IV) shown below, R²⁰ is 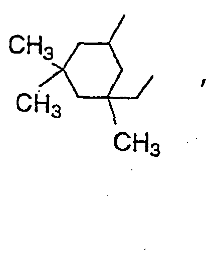 R²¹ and R²² are each 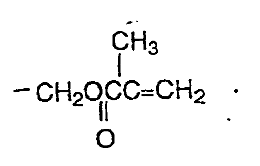
M-5
   In formula (IV) shown below, R²⁰ is 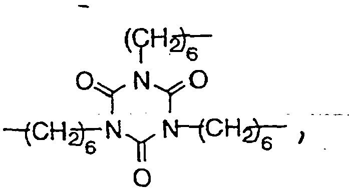 R²¹ is 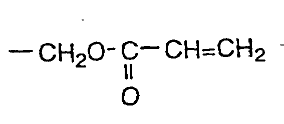 and R²² is 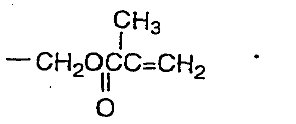 Formula (IV) 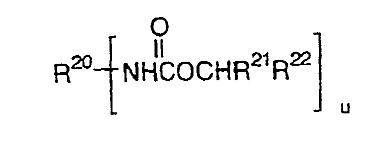
M-6

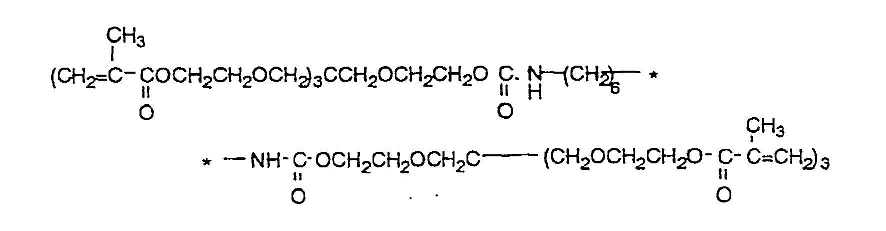

The structures of Compounds 1 to 5 are illustrated below:

### Compound 1

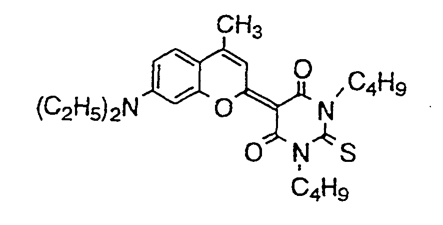

### Compound 2

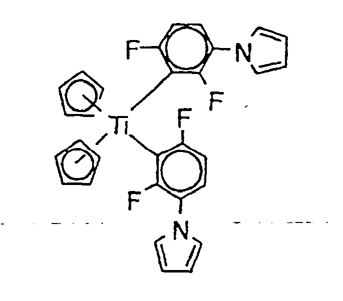

### Compound 3

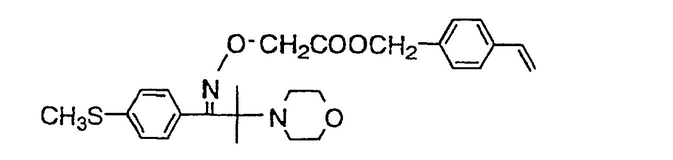

### Compound 4

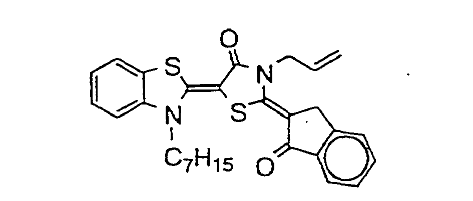

### Compound 5

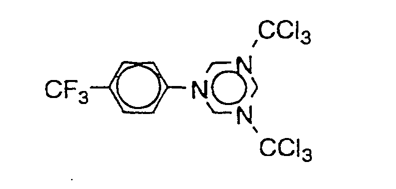

On the photo polymerizable layer, a water-soluble protective layer having the following composition was coated at a dry coverage of 2.5 g/m², and dried at 100°C for 3 minutes. Protective Coating Composition:

| Ingredient | Amount used |
|---|---|
| Polyvinyl alcohol (saponification degree: 98.5 mole %, polymerization degree: 550) | 22 g |
| Nonionic surfactant (BMALBX NP-10, trade name, produced by Nippon Emulsion Co., Ltd.) | 0.5 g |

Each of the thus prepared lithographic printing plate precursors was exposed imagewise to light (beam) of various energies by the use of a plate setter (SHG-YAG, 532 nm), Plate Jet 4 (produced by Cymbolic Sciences Co.) under a condition that the screen ruling was adjusted to 175 lpi and the resolution, was adjusted to 2540 dpi.

Thereafter, each printing plate precursor was further subjected to post-baking treatment at 110°C for 12 seconds with the purpose of heightening the curing degree of the film.

The development was performed using an automatic developing machine 850NX (trade name, made by Fuji Photo Film Co., Ltd.) under a condition that each of printing plate precursor samples was immersed for 15 seconds in a 30°C solution prepared by diluting a developer DP-4 (trade name, produced by Fuji Photo Film Co., Ltd.) with water by a factor of 18.

The gumming was carried out with a solution prepared by diluting a gum solution FP-2W (trade name, produced by Fuji Photo Film Co., Ltd.) with water in a ratio of 1:1.

The thus made printing plates were evaluated in the following ways.

The sensitivity of each sample was defined as the quantity of energy applied to the plate surface for reproducing 2 % halftone dots, which was expressed using the mJ/cm² unit.

The evaluation of a press life was done using a printing press, Model SOR-KZ (made by Heidelberg A.G.), a 2 % dilute solution of Emerald Premium MXE (produced by Anchor Co.) as fountain solution, and ink GEOS-G(N) (produced by Dai-Nippon Ink & Chemicals, Inc.).

The solid-area press life was expressed in terms of the number of normally printed sheets which were free of blank spots in the solid areas.

The highlight press life was expressed in terms of the number of printed sheets on which 2 % halftone dots under a screen ruling of 175 lpi were reproduced.

The tackiness of the photo polymerizable layer provided in each sample was evaluated as follows: An aluminum sheet was superimposed on a plate coated with each photo polymerizable layer alone, passed between 60°C rolls under a between-roll pressure of 15 kg/cm², and examined for extent of the transfer of the photo polymerizable layer to the aluminum sheet. When the transfer was a small extent, the tackiness was symbolized as the mark O.

When the transfer was a large extend, the tackiness was symbolized as the mark △.

The results obtained are shown in Table 2.

**Table 2**

| | Compound used | | | | | Binder (amount used | Monomer (amount used | Sensi-tivity (mJ/cm ²) | Solid-area press life | High-light press life | Tacki-ness of photo polymer izable layer |
|---|---|---|---|---|---|---|---|---|---|---|---|
| | 1 | 2 | 3 | 4 | 5 | | | | | | |
| Example 1 | 0.15g | 0.2 g | 0.5 g | - | - | B-3 (2.0 g) | M-1 (2.0 g) | 0.08 | 18×10⁴ | 6×10⁴ | ○ |
| Example 2 | 0.15 g | 0.2 g | 0.5 g | - | - | B-3 (2.0 g) | M-2 (2.0 g) | 0.08 | 20×10⁴ | 7×10⁴ | ○ |
| Example 3 | 0.15 g | 0.2 g | 0.5 g | - | | B-3 (2.0 g) | M-3 (2.0 g) | 0.08 | 20×10⁴ | 7×10⁴ | ○ |
| Example 4 | 0.15 g | 0.2 g | 0.5 g | - | - | B-3 (2.0 g) | M-4 (2.0 g) | 0.08 | 20×10⁴ | 7×10⁴ | ○ |
| Example 5 | 0.15 g | 0.2 g | 0.5 g | - | - | B-3 (2.0 g) | M-5 (2.0 g) | 0.08 | 18×10⁴ | 6×10⁴ | ○ |
| Example 6 | 0.15 g | 0.2 g | 0.5 g | - | - | B-3 (2.0 g) | M-6 (2.0 g) | 0.08 | 18×10⁴ | 6×10⁴ | ○ |
| Example 7 | 0.15 g | 0.2 g | 0.5 g | - | - | B-1 (2.0 g) | M-2 (2.0 g) | 0.08 | 20×10⁴ | 7×10⁴ | ○ |
| Example 8 | 0.15 g | 0.2 g | 0.5 g | - | - | B-2 (2.0 g) | M-2 (2.0 g) | 0.08 | 18×10⁴ | 6×10⁴ | ○ |
| Example 9 | 0.15 g | 0.2 g | 0.5 g | - | - | B-4 (2.0 g) | M-2 (2.0 g) | 0.08 | 20×10⁴ | 7×10⁴ | ○ |
| Example 10 | 0.15 g | 0.2 g | 0.5 g | - | - | B-5 (2.0 g) | M-2 (2.0 g) | 0.08 | 20×10⁴ | 7×10⁴ | ○ |
| Example 11 | 0.15 g | 0.2 g | 0.5 g | | | B-1 (2.0 g) | M-1 (1.0 g) /M-2 (0.5 g) | 0.08 | 20×10⁴ | 7×10⁴ | ○ |
| Example 12 | 0.15 g | 0.2 g | 0.5 g | | | B-1 (2.0 g) /B-3 (1.0 g) | M-1 (1.0 g) /M-2 (0.5 g) | 0.08 | 20×10⁴ | 7×10⁴ | ○ |
| Example 13 | - | - | 0.5 g | 0.15 g | 0.2 g | B-1 (2.0 g) | M-2 (2.0 g) | 0.08 | 18×10⁴ | 6×10⁴ | ○ |
| Example 14 | - | - | 0.5 g | 0.15g | 0.2 g | B-3 (2.0 g) | M-2 (2.0 g) | 0.08 | 20×10⁴ | 7×10⁴ | ○ |
| Compar. Example 1 | 0.15 g | 0.2 g | 0.5 g | - | - | B-6 (2.0 g) | M-2 (2.0 g) | 0.12 | 13×10⁴ | 2×10⁴ | △ |
| Compar. Example 2 | 0.15 g | 0.2 g | 0.5 g | - | - | B-7 (2.0 g) | M-2 (2.0 g) | 0.12 | 13×10⁴ | 2×10⁴ | △ |

By the use of polyvinyl acetals having an alkali-soluble group as binder component, the lithographic printing plate precursors of Examples 1 to 14 were increased in sensitivity and made extensive improvements in press lives, especially in a highlight press life (small-dot reproducibility).

For the purpose of examining the compatibleness of binders with monomers, the photo polymerizable compositions prepared in Examples 1 to 14 were each coated and dried on a polyethylene terephthalate film so as to have a dry coverage of 1.5 g/m², and further allowed to stand at 60°C for three days. As a result, no change was observed in every film, and so the present photo polymerizable compositions can be considered to have good compatibility.

As demonstrated above, the present lithographic printing plate precursors achieved improvements in sensitivity and press lives.

### ADVANTAGES OF THE INVENTION

In accordance with the present invention, the lithographic printing plate precursor comprises as binder component polyvinyl acetal having alkali-soluble groups, and so it can achieve high sensitivity in direct platemaking by exposure to laser and ensure excellent mechanical strength in the lithographic printing plate. In particular, the present printing plate precursor enables extensive improvement in highlight characteristics (small-dot reproducibility).

In addition, the photo polymerizable layer according to the present invention has reduced tackiness, and so it is convenient for the production using a coating technique.

## Claims

1. A lithographic printing plate precursor comprising a photosensitive layer provided on a substrate, said photosensitive layer being a photo-polymerizable layer comprising an addition polymerizable monomer, a photo-polymerization initiator and a polyvinyl acetal having alkali-soluble groups represented by the following formula (I) : 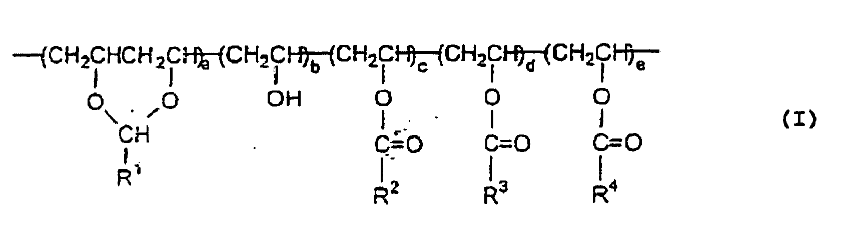 wherein R¹ and R² each represents an unsubstituted or substituted alkyl group or a hydrogen atom; R⁴ represents an aliphatic or aromatic hydrocarbon group which may have a hydroxyl group or a nitrile group; a and b each represent a positive number; c and e each represents a number of 0 or more; d represents a number of more than 0; and R³ represents a group selected from:

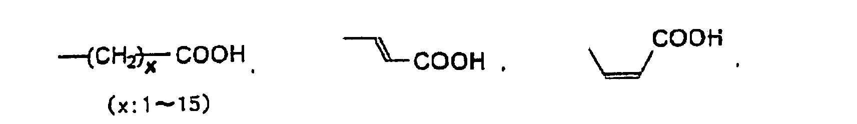

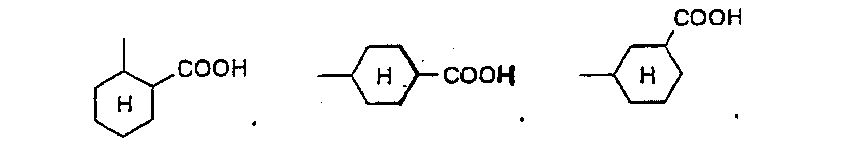

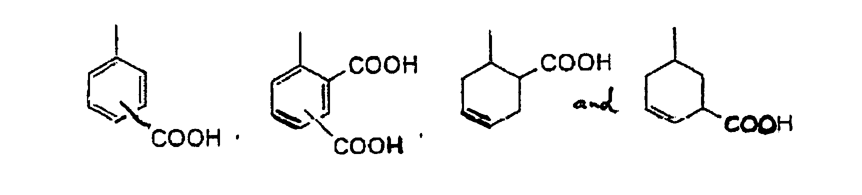

2. A lithographic printing plate precursor according to claim 1, wherein said polyvinyl acetal having alkali-soluble groups is used in a proportion of from 10 to 90 % by weight to the total ingredients in the photo-polymerizable layer.

3. A lithographic printing plate precursor according to claim 1, wherein said addition polymerizable monomer is used in a proportion of from 5 to 95 % by weight to the total ingredients in the photo-polymerizable layer.

4. A lithographic printing plate precursor according to claim 1, wherein said photo-polymerization initiator is used in a proportion of from 0.01 to 70 % by weight to the total of the binder component and the addition polymerizable monomer.

5. A lithographic printing plate precursor according to Claim 1, wherein the coverage of the photo-polymerizable layer in said lithographic printing plate precursor is 0.1-10 g/m² on a dry weight basis.

## Patentansprüche

1. Lithografie-Druckplattenvorläufer, umfassend eine fotoempfindliche Schicht, die auf einem Substrat vorgesehen ist, wobei die fotoempfindliche Schicht eine fotopolymerisierbare Schicht ist, umfassend ein additionspolymerisierbares Monomer, einen Fotopolymerisationsinitiator und ein Polyvinylacetal, das durch die folgende Formel (I) dargestellte alkalilösliche Gruppen aufweist: 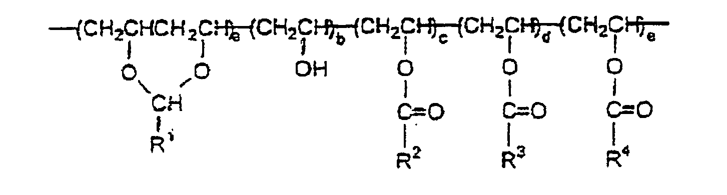 worin R¹ und R² jeweils eine unsubstituierte oder substituierte Alkylgruppe oder ein Wasserstoffatom darstellen; R⁴ eine aliphatische oder aromatische Kohlenwasserstoffgruppe, die eine Hydroxylgruppe oder eine Nitrilgruppe aufweisen kann, darstellt; a und b jeweils eine positive Zahl darstellen; c und e jeweils eine Zahl von 0 oder grösser darstellen; d eine Zahl von grösser als 0 darstellt; und R³ eine Gruppe darstellt, die ausgewählt ist aus:

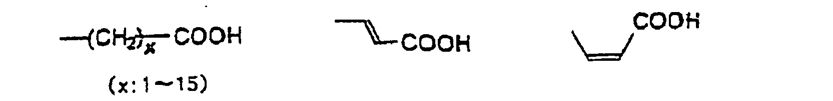

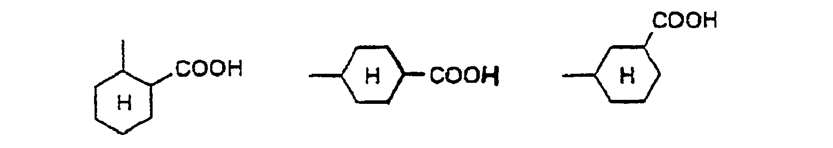

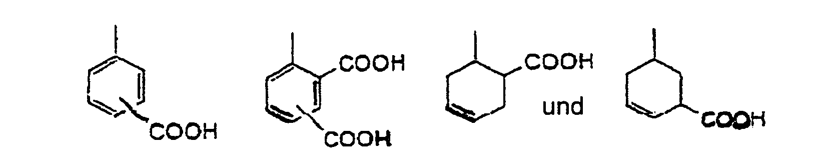

2. Lithografie-Druckplattenvorläufer gemäss Anspruch 1, worin das Polyvinylacetal, das alkalilösliche Gruppen aufweist, in einem Anteil von 10 bis 90 Gew.% der Gesamtinhaltsstoffe in der fotopolymerisierbaren Schicht verwendet wird.

3. Lithografie-Druckplattenvorläufer gemäss Anspruch 1, worin das additionspolymerisierbare Monomer in einer Menge von 5 bis 95 Gew.% der gesamten Inhaltsstoffe in der fotopolymerisierbaren Schicht verwendet wird.

4. Lithografie-Druckplattenvorläufer gemäss Anspruch 1, worin der Fotopolymerisationsinitiator in einer Menge von 0,01 bis 70 Gew.%, bezogen auf die Gesamtheit der Bindemittelkomponente und des additionspolymerisierbaren Monomers, verwendet wird.

5. Lithografie-Druckplattenvorläufer gemäss Anspruch 1, worin die Bedeckungsmenge der fotopolymerisierbaren Schicht in dem Lithografie-Druckplattenvorläufer 0,1 bis 10 g/m², auf Trockengewichtbasis, beträgt.

## Revendications

1. Précurseur de plaque d'impression lithographique comprenant une couche photosensible disposée sur un substrat, ladite couche photosensible étant une couche photopolymérisable comprenant une monomère polymérisable par addition, un initiateur de photopolymérisation et un acétal de polyvinyle ayant des groupes solubles dans l'alcali représenté par la formule suivante (I) : 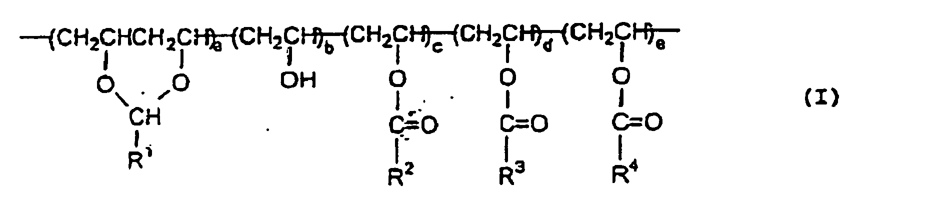 dans lequel R¹ et R² représentent chacun un groupe alkyle non substitué ou substitué ou un atome d'hydrogène ; R⁴ représente un groupe hydrocarbure aliphatique ou aromatique qui peut avoir un groupe hydroxyle ou un groupe nitrile ; a et b représentent chacun un nombre positif ; c et e représentent chacun un nombre de 0 ou plus ; d représente un nombre supérieur à 0 ; et R³ représente un groupe sélectionné à partir de :

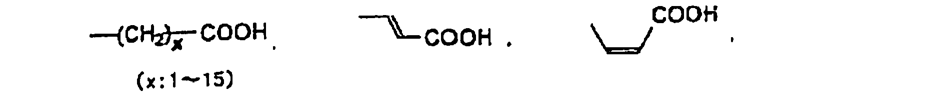

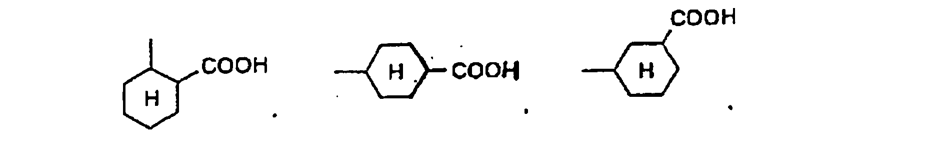

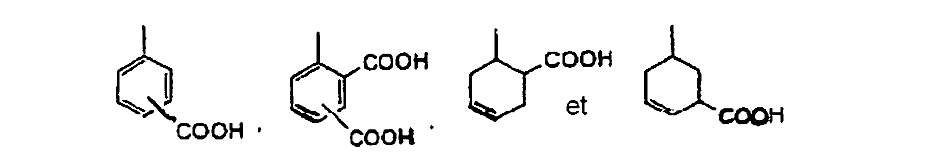

2. Précurseur de plaque d'impression lithographique selon la revendication 1, dans lequel ledit acétal de polyvinyle ayant des groupes solubles dans l'alcali est utilisé dans une proportion de 10 à 90 % en poids par rapport aux ingrédients totaux dans la couche photopolymérisable.

3. Précurseur de plaque d'impression lithographique selon la revendication 1, dans lequel ledit monomère polymérisable par addition est utilisé dans une proportion de 5 à 95 % en poids par rapport aux ingrédients totaux dans la couche photopolymérisable.

4. Précurseur de plaque d'impression lithographique selon la revendication 1, dans lequel ledit initiateur de photopolymérisation est utilisé dans une proportion de 0,01 à 70 % en poids par rapport au total du composant de liant et du monomère polymérisable par addition.

5. Précurseur de plaque d'impression lithographique selon la revendication 1, dans lequel la couverture de la couche photopolymérisable dans ledit précurseur de plaque d'impression lithographique est de 0,1 à 10 g/m² sur une base de poids sec.
